# EUROPEAN PATENT SPECIFICATION

(11) **EP 2 471 655 B1**
(45) Date of publication and mention of the grant of the patent: **17.08.2016**
(21) Application number: 11195871.6
(22) Date of filing: 28.12.2011
(51) Int. Cl.: B41C 1/10

(54) **Lithographic printing plate precursor and lithographic printing method**
Lithographiedruckplattenvorläufer und Lithographiedruckverfahren
Précurseur de plaque d'impression lithographique et procédé d'impression lithographique

(30) Priority: 28.12.2010 JP 2010294336; 06.12.2011 JP 2011267349
(43) Date of publication of application: 04.07.2012
(73) Proprietor: Fujifilm Corporation, Minato-ku Tokyo (JP)
(72) Inventor: Oohashi, Hidekazu, Shizuoka (JP); Koyama, Ichiro, Shizuoka (JP); Kanehisa, Mayuko, Shizuoka (JP); Mori, Takanori, Shizuoka (JP)
(74) Representative: Hoffmann Eitle

(56) References cited:
- EP-A1- 2 236 291
- WO-A1-2005/071488
- JP-A- 2004 317 543
- JP-A- 2007 249 036

## Description

### FIELD OF THE INVENTION

The present invention relates to a lithographic printing plate precursor and a lithographic printing method using the same. More particularly, it relates to a lithographic printing plate precursor capable of undergoing a direct plate making by image exposure with laser and a plate making method (printing method) of the lithographic printing plate precursor by on-press development

### BACKGROUND OF THY INVENTION

In general, a lithographic printing plate is composed of an oleophilic image area accepting ink and a hydrophilic non-image area accepting dampening water in the process of printing. Lithographic printing is a printing method utilizing the nature of water and oily ink to repel with each other and comprising rendering the oleophilic image area of the lithographic printing plate to an ink-receptive area and the hydrophilic non-image area thereof to a dampening water-receptive area (ink-unreceptive area), thereby making a difference in adherence of the ink on the surface of the lithographic printing plate, depositing the ink only to the image area, and then transferring the ink to a printing material, for example, paper.

In order to produce the lithographic printing plate, a lithographic printing plate precursor (PS plate) comprising a hydrophilic support having provided thereon an oleophilic Photosensitive resin layer (image-recording layer) is used. Specifically, the PS plate is exposed through a mask, for example, a lith film, and then subjected to development processing, for example, with an alkaline developer to remove the unnecessary image-recording layer corresponding to the non-image area by dissolving while leaving the image-recording layer corresponding to the image area, thereby obtaining the lithographic printing plate.

Due to the recent progress in the technical field, nowadays the lithographic printing plate can be obtained by a CTP (computer-to-plate) technology. Specifically, a lithographic printing plate precursor is directly subjected to scanning exposure using laser or laser diode without using a lith film and developed to obtain a lithographic printing plate.

With the progress described above, the issue on the lithographic printing plate precursor has transferred to improvements, for example, in image-forming property corresponding to the CTP technology, printing property or physical property. Also, with the increasing concern about global environment, as another issue on the lithographic printing plate precursor, an environmental problem on waste liquid discharged accompanying the wet treatment, for example, development processing comes to the front.

In response to the environmental problem, simplification of development or plate making or non-processing has been pursued. As one method of simple plate making, a method referred to as "on-press development" is practiced. Specifically, according to the method after exposure of a lithographic printing plate precursor, the lithographic printing plate precursor is mounted as it is on a printing machine without conducting conventional development and removal of the unnecessary area of image-recording layer is performed at an early stage of printing step.

Also, as a method of simple development, a method referred to as "gum development" is practiced wherein the removal of the unnecessary area of image-recording layer is performed using not a conventional high alkaline developer but a finisher or gum solution of near-neutral pH.

In the simplification of plate making operation as described above, a system using a lithographic printing plate precursor capable of being handled in a bright room or under a yellow lump and a light source is preferred from the standpoint of workability. Thus, as the light source, a semiconductor laser emitting an infrared ray having a wavelength from 760 to 1,200 or a solid laser, for example, YAG laser, is used. An UV laser is also used.

As the lithographic printing plate precursor capable of undergoing on-press development, for instance, a lithographic printing plate precursor having provided on a hydrophilic support, an image-recording layer (heat-sensitive layer) containing microcapsules having a polymerizable compound encapsulated therein is described in JP-A-2001-277740 (the term "JP-A" as used herein means an "unexamined published Japanese patent application") and JP-A-2001-277742. A lithographic printing plate precursor having provided on a support, an image-recording layer (photosensitive layer) containing an infrared absorbing agent, a radical polymerization initiator and a polymerizable compound is described in JP-A-2002-287334. A lithographic printing plate precursor capable of undergoing on-press development having provided on a support, an image-recording layer containing a polymerizable compound and a graft polymer having a polyethylene oxide chain in its side chain or a block polymer having a polyethylene oxide block is described in U.S. Patent Publication No. 2003/0064318.

In order to improve on-press development property and printing durability of a lithographic printing plate precursor capable of undergoing on-press development, it is described to use a polymer compound (hereinafter, also referred to as a "star polymer") in which the main chain is branched to three or more branches in an image-recording layer in JP-A-2007-249036.

A star polymer and a paint composition using the same are described in JP-A-6-87908. However, in JP-A-6-87908, there is no example of using the star polymer in a printing plate.
JP 2004 317543 A relates to a lithographic printing plate precursor which comprises a support and an image-recording layer containing an alkali-soluble polymer having a star structure, a radical polymerizable compound and a radical polymerization initiator. The alkali-soluble polymer is a star polymer which has a radical polymerizable group. WO 2005/071488 A1 relates to a lithographic printing plate precursor comprising (a) an untreated or pretreated substrate and (b) a radiation-sensitive coating comprising (i) at least one polymeric binder soluble or swellable in aqueous alkaline developers, (ii) at least one free-radical polymerizable monomer and/or oligomer comprising at least one non-aromatic C-C double bond and at least one SH group in the molecule and (iii) a radiation-sensitive initiator or initiator system for free- radical polymerization. EP 2 236 291 A1 describes a lithographic printing plate precursor comprising an aluminum support subjected to a roughening treatment and an image-recording layer comprising an infrared absorbing agent, a radical polymerization initiator, a radical polymerizable monomer, a compound having two or more mercapto group-containing groups per molecule and a polymer particle containing a polyalkylene oxide segment.

### SUMMARY OF THE INVENTION

An object of the present invention is to provide a lithographic printing plate precursor which can provide a lithographic printing plate having high on-press development property and being excellent in printing durability, and a lithographic printing method using the same.

As a result of the intensive investigations for achieving the above-described object, the inventors have been found that a lithographic printing plate precursor which can provide a lithographic printing plate being excellent in both on-press development property and printing durability can be obtained by using a binder (hereinafter, abbreviated simply as a "binder") which comprises a multifunctional thiol having from 6 to 10 functional groups as a nucleus and polymer chains connected to the nucleus through a sulfide bond and the polymer chains have a polymerizable group.

Specifically, the present invention includes the following items.
(1) A lithographic printing plate precursor comprising a support and an image-recording layer containing a binder, a radical polymerizable compound and a radical polymerization initiator, wherein the binder comprises a multifunctional thiol having from 6 to 10 thiol groups as a nucleus and polymer chains connected to the nucleus through sulfide bonds derived from thiol groups and the polymer chains have a polymerizable group.
(2) The lithographic printing plate precursor as described in (1) above, wherein the polymerizable group is an acryl group or a methacryl group.
(3) The lithographic printing plate precursor as described in (1) or (2) above, wherein the polymer chain has a substituent represented by formula (1) shown below:

   -(CH₂CH₂O)ₙR Formula (1)

   In formula (1), n represents an integer from 1 to 100, and R represents a hydrogen atom or an alkyl group having from 1 to 18 carbon atoms.
(4) The lithographic printing plate precursor as described in (3) above, wherein n represents an integer from 1 to 4, and R represents a hydrogen atom or a methyl group.
(5) The lithographic printing plate precursor as described in any one of (1) to (4) above, wherein the polymer chain is a polymer chain obtained by radical polymerization of at least one of a (meth)acrylic acid monomer, a styrene monomer and a vinyl monomer.
(6) The lithographic printing plate precursor as described in any one of (1) to (5) above, wherein the image-recording layer contains as the radical polymerization initiator, an onium salt compound and one of an organic borate salt compound and a carboxylic acid-based compound.
(7) The lithographic printing plate precursor as described in (6) above, wherein the onium salt compound is an iodonium salt, a sulfonium salt or an azinium salt.
(8) The lithographic printing plate precursor as described in any one of (1) to (7) above, wherein the image-recording layer further contains an infrared absorbing agent.
(9) The lithographic printing plate precursor as described in any one of (1) to (8) above, which further comprises a protective layer so that the support, the image-recording layer and the protective layer are provided in this order.
(10) The lithographic printing plate precursor as described in any one of (1) to (9) above, wherein an undercoat layer is provided between the support and the image-recording layer.
(11) The lithographic printing plate precursor as described in any one of (1) to (10) above, which is capable of printing after image exposure with laser, by mounting on a printing machine and supplying printing ink and dampening water to remove an unexposed area of the image-recording layer.
(12) The lithographic printing plate precursor as claimed in any one of (1) to (11), wherein the polymer compound is selected from one or more kinds of polymers P-1 to P-14 as listed in the table of claim 12, wherein the central nucleus SB-2 has a ratio of mole number in % of SH group to the total mole number of the monomers of 1 %, wherein SB-2 represents dipentaerythritol hexakis(3-mercaptopropionate) and wherein Mw represents a weight average molecular weight measured by GPC calculated in terms of polystyrene.
(13) A lithographic printing method comprising after image exposure of the lithographic printing plate precursor as described in (11) above with laser, mounting on a printing machine and supplying printing ink and dampening water to remove an unexposed area of the image-recording layer, thereby conducting printing.

According to the invention, the object of improving both on-press development property of the lithographic printing plate precursor and printing durability of the lithographic printing plate provided by the lithographic printing plate precursor can be achieved by using, as a binder in the image-recording layer, a star polymer comprising a multifunctional thiol having from 6 to 10 functional groups as a nucleus and polymer chains connected to the nucleus through a sulfide bond and the polymer chains have a polymerizable group.

The functional mechanism of the invention is not quite clear but it is estimated as follows. The polymer shape becomes compact by making a multi-branched star polymer having from 6 to 10 branched points and as a result, tangle of polymer chains is decreased and the polymer is easy to be dissolved to improve the development property. Further, since the branched point originally present plays a part of a crosslinking point when the polymerizable group is reacted by the imagewise exposure, the crosslink density increases to improve the printing durability.

According to the present invention, a lithographic printing plate precursor which can provided a lithographic printing plate having high on-press development property and being excellent in printing durability and a lithographic printing method using the same can be provided.

### DETAILED DESCRIPTION OF THE INVENTION

### [Lithographic printing plate precursor]

The lithographic printing plate precursor according to the invention is a lithographic printing plate precursor comprising a support and an image-recording layer containing a binder, a radical polymerizable compound and a radical polymerization initiator. The invention will be described in detail below.

### <Binder>

The binder for use in the invention is a polymer compound comprising a multifunctional thiol having from 6 to 10 thiol groups as a nucleus and polymer chains connected to the nucleus through sulfide bonds derived from these thiol groups and the polymer chains have a polymerizable group. As the binder for use in the invention, any polymer can be preferably used as long as it has the nucleus and polymer chains as described above.

As the multifunctional thiol having from 6 to 10 thiol groups which can be used as the nucleus, any compound having from 6 to 10 thiol groups per molecule can be used. The multifunctional thiol compound includes the compounds described below.

### (Compound A)

Compound obtained by a method of reacting a sulfuration agent, for example, thiourea, potassium thiocyanate or thioacetic acid with an electrophilic agent, for example, a halide or a sulfonic acid ester of an alcohol, followed by various treatments.

Specific examples of Compound A include compounds set forth below, but the invention should not be construed as being limited thereto.

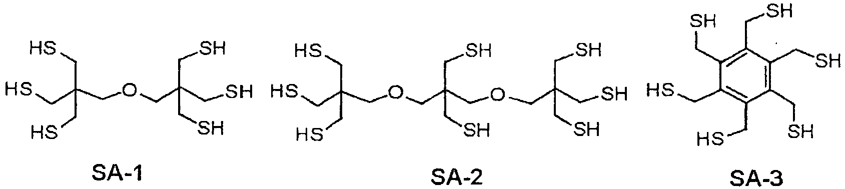

### (Compound B)

Compound obtained by a dehydration condensation reaction between an alcohol and a carboxylic acid having a thiol group.

Among them, a compound obtained by a condensation reaction between a multifunctional alcohol having from 6 to 10 functional groups and a carboxylic acid having one thiol group is preferred. A method wherein the multifunctional alcohol and a carboxylic acid having a protected thiol group are subjected to dehydration condensation and then the resulting product is subjected to deprotection can also be used.

Specific examples of the multifunctional alcohol include dipentaerythritol, tripentaerythritol, sorbitol, mannitol, iditol, dulcitol and inositol. Dipentaerythritol, tripentaerythritol and sorbitol are preferred, and dinentaervthritol and tripentaerythritol are particularly preferred.

Specific examples of the carboxylic acid having a thiol group include mercaptoacetic acid, 3-mercaptopropionic acid, 2-mercaptopropionic acid, N-acetylcysteine,
N-(2-mercaptopropionyl)glycine and thiosalicylic acid. Mercaptoacetic acid, 3-mercaptopropionic acid, 2-mercaptopropionic acid, N-acetylcysteine and N-(2-mercaptopropionyl)glycine are preferred, 3-mercaptopropionic acid, 2-mercaptopropionic acid, N-acetylcysteine and N-(2-mercaptopropionyl)glycine are more preferred, and 3-mercaptopropionic acid, N-acetylcysteine and N-(2-mercaptopropionyl)glycine are particularly preferred.

Specific examples of Compound B include compounds set forth in Table 1 below, but the invention should not be construed as being limited thereto.

**TABLE 1: Specific Examples of Compound B**

| Multifunctional Alcohol | Carboxylic Acid Having Thiol Group | | | | | |
|---|---|---|---|---|---|---|
| | Mercaptoacetic Acid | 3-Mercaptopr-opionic Acid | 2-Mercaptopropionic Acid | N-Acetylcysteine | N-(2-Mercaptopropionyl)glycine | Thiosalicylic Acid |
| Dipentaerythritol | SB-1 | SB-2 | SB-3 | SB-4 | SB-5 | SB-6 |
| Tripentaerythritol | SB-7 | SB-8 | SB-9 | SB-10 | SB-11 | SB-12 |
| Sorbitol | SB-13 | SB-14 | SB-15 | SB-16 | SB-17 | SB-18 |
| Mannitol | SB-19 | SB-20 | SB-21 | SB-22 | SB-23 | SB-24 |
| Iditol | SB-25 | SB-26 | SB-27 | SB-28 | SB-29 | SB-30 |
| Dulcitol | SB-31 | SB-32 | SB-33 | SB-34 | SB-35 | SB-36 |
| Inositol | SB-37 | SB-38 | SB-39 | SB-40 | SB-41 | SB-42 |

Of the specific examples, SB-1 to SB-23, SB-25 to SB-29, SB-31 to SB-35 and SB-37 to SB-41 are preferred, SB-2 to SB-5, SB-8 to SB-11 and SB-14 to SB-17 are more preferred, and SB-2, SB-4, SB-5, SB-8, SB-10 and SB-11 are particularly preferred. Since the multifunctional thiol synthesized from these compounds has a long distance between the thiol groups and a small steric hindrance, the desired star structure can be formed.

### (Compound C)

Compound obtained by a dehydration condensation reaction between an amine and a carboxylic acid having a thiol group.

Among them, a compound obtained by a condensation reaction between a multifunctional amine having from 6 to 10 functional groups and a carboxylic acid having one thiol group is preferred. A method wherein the multifunctional amine and a carboxylic acid having a protected thiol group are subjected to dehydration condensation and then the resulting product is subjected to deprotection can also be used.

Specific examples of the multifunctional amine include pentaethylenehexamine. Specific examples of the carboxylic acid having a thiol group include mercaptoacetic acid, 3-mercaptopropionic acid, 2-mercaptopropionic acid, N-acetylcysteine, N-(2-mercaptopropionyl)glycine and thiosalicylic acid. Mercaptoacetic acid, 3-mercaptopropionic acid, 2-mercaptopropionic acid, N-acetylcysteine and N-(2-mercaptopropionyl)glycine are preferred, 3-mercaptopropionic acid, 2-mercaptopropionic acid, N-acetylcysteine and N-(2-mercaptopropionyl)glycine are more preferred, and 3-mercaptopropionic acid, N-acetylcysteine and N-(2-mercaptopropionyl)glycine are particularly preferred.

Specific examples of Compound C include compounds set forth in Table 2 below, but the invention should not be construed as being limited thereto.

**TABLE 2: Specific Examples of Compound C**

| Multifunctional Amine | Carboxylic Acid Having Thiol Group | | | | | |
|---|---|---|---|---|---|---|
| | Mercaptoacetic Acid | 3-Mercaptopropionic Acid | 2-Mercaptopropionic Acid | N-Acetylcysteine | N-(2-Mercaptopropionyl)glycine | Thiosalicylic Acid |
| Pentaethylenehexamine | SC-1 | SC-2 | SC-3 | SC-4 | SC-5 | SC-6 |

Of the specific examples, SC-1 to SC-5 are preferred, SC-2 to SC-5 are more preferred, and SC-2, SC-4 and SC-5 are particularly preferred. Since the multifunctional thiol synthesized from these compounds has a long distance between the thiol groups and a small steric hindrance, the desired star structure can be formed.

### (Compound D)

Compound obtained by a dehydration condensation reaction between a compound having a hydroxy group and an amino group and a carboxylic acid having a thiol group.

Among them, a compound obtained by a condensation reaction between a multifunctional alcoholamine having from 6 to 10 functional groups and a carboxylic acid having one thiol group is preferred. A method wherein the multifunctional alcoholamine and a carboxylic acid having a protected thiol group are subjected to dehydration condensation and then the resulting product is subjected to deprotection can also be used.

Specific examples of the multifunctional alcoholamine include 1,3-bis[tris(hydroxymethyl)methylamino]propane, 1-amino-1-deoxy-D-sorbitol and N-methyl-D-glucamine. 1,3-bis[tris(hydroxymethyl)methylamino]propane and 1-amino-1-deoxy-D-sorbitol are preferred, and 1,3-bis[tris(tris(droxymethyl)methylamino]propane is particularly preferred. Specific examples of the carboxylic acid having a thiol group include mercaptoacetic acid, 3-mercaptopropionic acid, 2-mercaptopropionic acid, N-acetylcysteine, N-(2-mercaptopropionyl)glycine and thiosalicylic acid. Mercaptoacetic acid, 3-mercaptopropionic acid, 2-mercaptopropionic acid, N-acetylcysteine and N-(2-mercaptopropionyl)glycine are preferred, 3-mercaptopropionic acid, 2-mercaptopropionic acid, N-acetylcysteine and N-(2-mercaptopropionyl)glycine are more preferred, and 3-mercaptopropionic acid, N-acetylcysteine and N-(2-mercaptopropionyl)glycine are particularly preferred.

Specific examples of Compound D include compounds set forth in Table 3 below, but the invention should not be construed as being limited thereto.

**TABLE 3: Specific Examples of Compound D**

| Multifunctional Alcoholamine | Carboxylic Acid Having Thiol Group | | | | | |
|---|---|---|---|---|---|---|
| | Mercaptoacetic Acid | 3-Mercaptopropionic Acid | 2-Mercaptopropionic Acid | N-Acetylcysteine | N-(2-Mercaptopropionyl)glycine | ThiosaJicylic Acid |
| 1,3-Bis[tris(hydroxymethyl)-methylamino]propane | SD-1 | SD-2 | SD-3 | SD-4 | SD-5 | SD-6 |
| 1-Amino-1-deoxy-D-sorbitol | SD-7 | SD-8 | SD-9 | SD-10 | SD-11 | SD-12 |
| N-Methyl-D-glucamine | SD-13 | SD-14 | SD-15 | SD-16 | SD-17 | SD-18 |

Of the specific examples, SD-1 to SD-17 are preferred, SD-2 to SD-5 and SD-8 to SD-11 are more preferred, and SD-2, SD-4 and SD-5 are particularly preferred. Since the multifunctional thiol synthesized from these compounds has a long distance between the thiol groups and a small steric hindrance, the desired star structure can be formed.

### (Compound E)

Compound obtained by a dehydration condensation reaction between a carboxylic acid and an alcohol having a thiol group.

Among them, a compound obtained by a condensation reaction between a multifunctional carboxylic acid having from 3 to 10 functional groups and an alcohol having one or more thiol groups is preferred. A method wherein the multifunctional carboxylic acid and an alcohol having a protected thiol group are subjected to dehydration condensation and then the resulting product is subjected to deprotection can also be used.

Specific examples of the multifunctional carboxylic acid include aconitic acid, citric acid, tetrahydrofuran-2,3,4,5-tetracarboxylic acid,
2,2',2",2'"-[1,2-ethanediylidenetetrakis(thio)]tetrakisacetic acid, 1,3,5-cyclohexanetricarboxylic acid, 1,2,3,4-cyclobutanetetracarboxylic acid and 1,2,3,4,5,6-cyclohexanehexacarboxylic acid. Citric acid, tetrahydrofuran-2,3,4,5-tetracarboxylic acid, 1,3,5-cyclohexanetricarboxylic acid, 1,2,3,4-cyclobutanetetracarboxylic acid and 1,2,3,4,5,6-cyclohexanehexacarboxylic acid are preferred, and citric acid, 1,3,5-cyclohexanetricarboxylic acid, 1,2,3,4-cyclobutanetetracarboxylic acid and 1,2,3,4,5,6-cyclohexanehexacarboxylic acid are particularly preferred. Specific examples of the alcohol having a thiol group include 2-mercaptoethanol, 1-mercapto-2-propanol, 3-mercapto-1-prnpanol, 3-mercapto-2-butanol and 2,3-dimercapto-1-propanol. 2-Memaptoethanol, 3-mercapto-1-propanoi and 23-dimercapto-1-propanol are preferred, 2-Mercaptoethanol and 3-mercapto-1-propanol are more preferred, and 3-mercapto-1-propanol is particularly preferred.

Specific examples of Compound E include compounds set forth in Table 4 below, but the invention should not be construed as being limited thereto.

**TABLE 4: Specific Examples of Compound E**

| Multifunctional Carboxylic Acid | Alcohol Having Thiol Group | | | | |
|---|---|---|---|---|---|
| | 2-Mercaptoethanol | 1-Mercapto-2-propanol | 3-Mercapto-1-propanol | 3-Mercapto-2-butanol | 2,3-Dimercapto-1-propanol |
| Aconitic acid | - | - | - | - | SE-1 |
| Citric acid | - | - | - | - | SE-2 |
| Tetrahydrofuran-2,3,4,5-tetracarboxylic acid | - | - | - | - | SE-3 |
| 2,2',2",2"'-[1,2-Ethanediylidenetetrakis(thio)]tetrakisacetic acid | - | - | - | - | SE-4 |
| 1,3,5-Cyclohexanetricarboxylic acid | - | - | - | - | SE-5 |
| 1,2,3,4-Cyclobutanetetracarboxylic acid | - | - | - | - | SE-6 |
| 1,2,3,4,5,6-Cyclohexanehaxacarboxylic acid | SE-7 | SE-8 | SE-9 | SE-10 | - |

Of the specific examples, SE-2, SE-3, SE-5 and SE-6 to SE-10 are preferred, SE-7 and SE-9 are more preferred, and SE-9 is particularly preferred. Since the multifunctional thiol synthesized from these compounds has a long distance between the thiol groups and a small steric hindrance, the desired star structure can be formed.

### (Compound F)

Compound obtained by a dehydration condensation reaction between a carboxylic acid and an amine having a thiol group.

Among them, a compound obtained by a condensation reaction between a multifunctional carboxylic acid having from 3 to 10 functional groups and an amine having one or more thiol groups is preferred. A method wherein the multifunctional carboxylic acid and an amine having a protected thiol group are subjected to dehydration condensation and then the resulting product is subjected to deprotection can also be used.

Specific examples of the compound include Condensation reaction product (SF-1) between 12,3,4,5,6-cyclohexanehexacarboxylic acid and 2-aminoethanethiol.

For instance, in order to obtain each of Compounds B to F having a thiol group which has the number of the functional group same as that in the multifunctional alcohol, multifunctional amine, multifunctional alcoholamine or multifunctional carboxylic acid that is used as the raw material, when an equivalent of the hydroxy group, an amino group or a carboxylic group which is involved in the reaction and included in the multifunctional alcohol, multifunctional amine, multifunctional alcoholamine or multifunctional carboxylic acid is taken as α and an equivalent of the carboxyl group, hydroxy group or an amino group which is involved in the reaction described above and included in the carboxylic acid having one thiol group and one carboxyl group, alcohol having one thiol group and one hydroxy group or amine having one thiol group and one amino group is taken as β, it is preferred to blend the respective components to react so that β is same as α or more than α.

For example, Compound SB-1 described above can be obtained by blending to react 6 moles or more, preferably 7 moles or more (6 equivalents or more, preferably 7 equivalents or more, as the equivalent of carboxyl group) to one mole of dipentaerythritol (6 equivalent as the equivalent of hydroxy group).

Of the multifunctional thiols, from the standpoint of printing durability and development property, Compounds A to E are preferred, Compounds A, B, D and E are more preferred, and Compounds A, B and D are particularly preferred.

The binder for use in the invention is a polymer compound comprising a multifunctional thiol as described above as a nucleus and polymer chains connected to the nucleus through a sulfide bond and the polymer chains have a polymerizable group. The polymer chain in the binder according to the invention includes a known vinyl-based polymer, a (meth)acrylic acid-based polymer and a styrene-based polymer, each of which can be produced by radical polymerization from a vinyl-based monomer, a (meth)acrylic acid-based monomer or a styrene-based monomer. (Meth)acrylic acid-based polymer is particularly preferred.

The binder for use in the invention has a polymerizable group, for example, an ethylenically unsaturated bond, for improving film strength of the image area as described in JP-A-2008-195018 in the main chain or side chain thereof, preferably in the side chain thereof. By the polymerizable group, crosslink is formed between the polymer molecules to accelerate curing.

As the polymerizable group, an ethylenically unsaturated group, for example, a (meth)acryl group, a vinyl group, an allyl group or a styryl group and an epoxy group are preferred, a (meth)acryl group, a vinyl group and a styryl group are more preferred in view of polymerization reactivity, and a (meth)acryl group is particularly preferred. The polymerizable group can be introduced into the polymer by a polymer reaction or copolymerization. For example, a reaction between a polymer having a carboxyl group in its side chain and glycidyl methacrylate or a reaction between a polymer having an epoxy group and a carboxylic acid having an ethylenically unsaturated group, for example, methacrylic acid can be utilized. The polymerizable groups may be used in combination thereof

The content of the polymerizable group in the binder is preferably from 0.1 to 10.0 mmol, more preferably from 0.25 to 7.0 mmol, most preferably from 0.5 to 5.5 mmol, per 1 g of the binder.

The binder according to the invention preferably further contains a hydrophilic group. The hydrophilic group contributes to impart the on-press development property to the image-recording layer. In particular, coexistence of the polymerizable group and the hydrophilic group makes it possible to maintain good balance between the printing durability and development property.

The hydrophilic group includes -SO₃M¹, -OH, -CONR¹R² (wherein M¹ represents a hydrogen ion, a metal ion, an ammonium ion or a phosphonium ion, and R¹ and R² each independently represents a hydrogen atom, an alkyl group, an alkenyl group or an aryl group, or R¹ and R² may be combined with each other to form a ring), -N⁺R³R⁴R⁵X⁻ (wherein R³ to R⁵ each represents an alkyl group having from 1 to 8 carbon atoms, and X⁻ represents a counter anion), a group represented by formula (1) shown below and a group represented by formula (2) shown below.

Formula (1): -(CH₂CH₂O)ₙR

Formula (2): -(C₃H₆O)ₘR

In the above formulae, n and m each independently represents an integer from 1 to 100, and R represents a hydrogen atom or an alkyl group having from 1 to 18 carbon atoms.

Of the hydrophilic groups, -CONR¹R², a group represented by formula (1) and a group represented by formula (2) are preferred, -CONR¹R² and a group represented by formula (1) are more preferred, and a group represented by formula (1) is particularly preferred. Further, of the groups represented by formula (1), n is more preferably from 1 to 10, and particularly preferably from 1 to 4. R is more preferably a hydrogen atom or an alkyl group having from 1 to 4 carbon atoms, and particularly preferably a hydrogen atom or a methyl group. The hydrophilic groups may be used in combination of two or more thereof.

Further, the binder according to the invention preferably substantially does not contain a carboxylic acid group, a phosphoric acid group and a phosphonic acid group. Specifically, the content of these acid groups is preferably less than 0.1 mmol/g, more preferably less than 0.05 mmol/g, and particularly preferably less than 0.03 mmol/g. When the content of these acid groups is less than 0.1 mmol/g, the development property is more improved.

Moreover, in order to control ink receptivity, an oleophilic group, for example, an allyl group, an aryl group, an aralkyl group or an alkenyl group may be introduced into the binder according to the invention. Specifically, a monomer containing an oleophilic group, for example, an alkyl methacrylate may be copolymerized.

Specific examples of the binder according to the invention are set forth below, but the invention should not be construed as being limited thereto.

| Polymer No. | Central Nucleus | | Polymer Chain | | | | | | Mw (x 10⁴) |
|---|---|---|---|---|---|---|---|---|---|
| | No. | % by Mole* 1 | Polymerizable Group | %by Mole | Hydrophilic Group | %by Mole | Other | % by Mole | |
| P-1 | SB-2 | 1 | 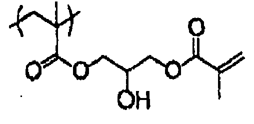 | 10 | 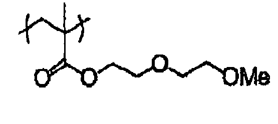 | 40 | 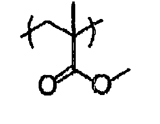 | 50 | 6.5 |
| P-2 | SB-2 | 1 | 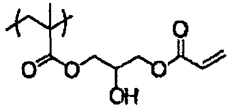 | 10 | 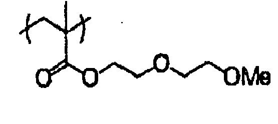 | 40 | 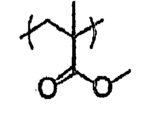 | 50 | 6.4 |
| P-3 | SB-2 | 1 | 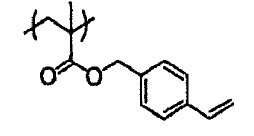 | 10 | 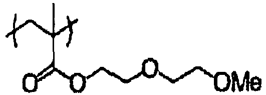 | 40 | 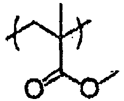 | 50 | 6.2 |
| P-4 | SB-2 | 1 | 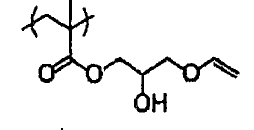 | 10 | 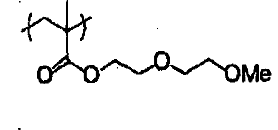 | 40 | 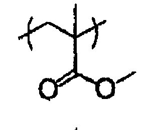 | 50 | 6.6 |
| P-5 | SB-2 | 1 | 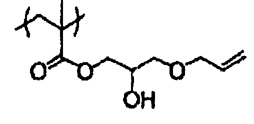 | 10 | 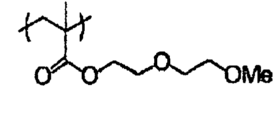 | 40 | 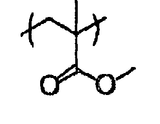 | 50 | 6.7 |
| P-6 | SB-2 | 1 | 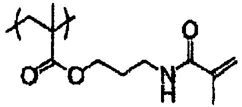 | 10 | 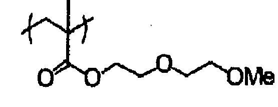 | 40 | 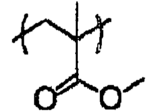 | 50 | 6.9 |
| P-7 | SB-2 | 1 | 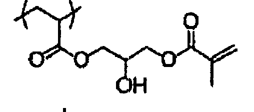 | 10 | 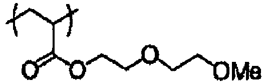 | 40 | 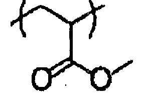 | 50 | 6.1 |
| P-8 | SB-2 | 1 | 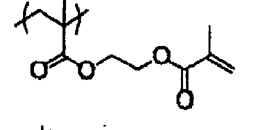 | 10 | 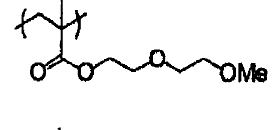 | 40 | 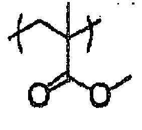 | 50 | 7.1 |
| P-9 | SB-2 | 1 | 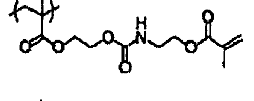 | 10 | 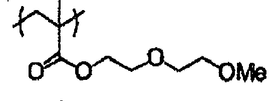 | 50 | 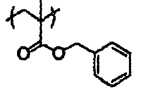 | 40 | 6.6 |
| P-10 | SB-2 | 1 | 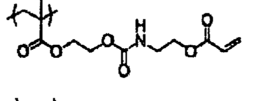 | 10 | 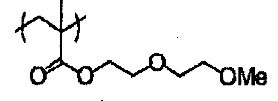 | 50 | 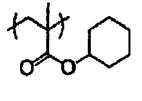 | 40 | 6.2 |
| P-11 | SB-2 | 1 | 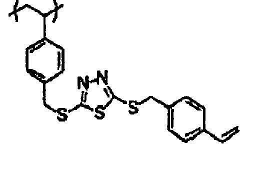 | 10 | 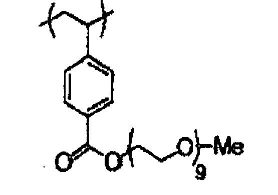 | 60 | 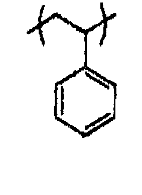 | 30 | 5.8 |
| P-12 | SB-2 | 1 | 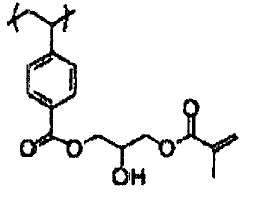 | 10 | 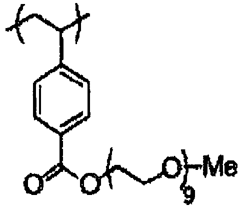 | 60 | 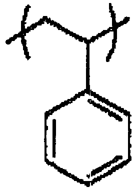 | 30 | 5.7 |
| P-13 | SB-2 | 1 | 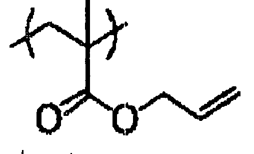 | 10 | 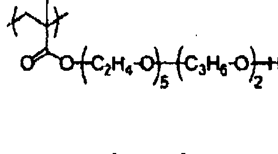 | 50 | 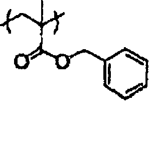 | 40 | 7.8 |
| P-14 | SB-2 | 1 | 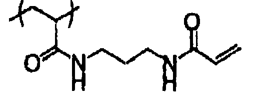 | 10 | 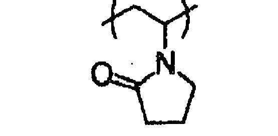 | 40 | 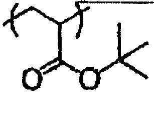 | 50 | 7.0 |

| | | | | | | | | | |
|---|---|---|---|---|---|---|---|---|---|
| *1: A ratio of mole number (%) of SH group to the total mole number of the monomers. | | | | | | | | | |

| Polymer No. | Central Nucleus | | Polymer Chain | | | | | | Mw (x 10⁴) |
|---|---|---|---|---|---|---|---|---|---|
| | No. | % by Mole* 1 | Polymerizable Group | % by Mole | Hydrophilic Group | % by Mole | Other | % by Mole | |
| P-15 | SB-2 | 1 | 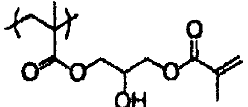 | 5 | 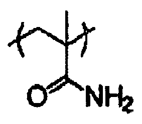 | 8 | 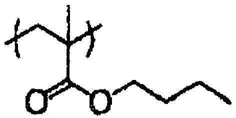 | 87 | 6.3 |
| P-16 | SB-2 | 1 | 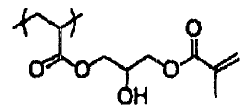 | 5 | 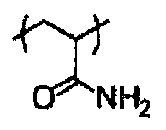 | 6 | 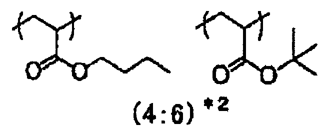 | 89 | 6.4 |
| P-17 | SB-2 | 1 | 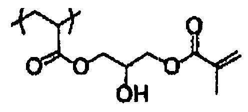 | 5 | 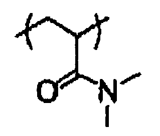 | 10 | 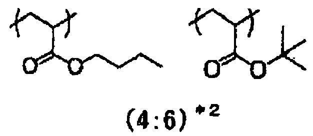 | 85 | 6.1 |
| P-18 | SB-2 | 1 | 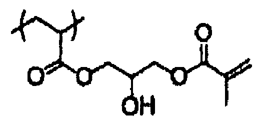 | 5 | 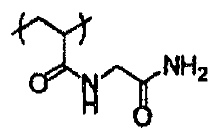 | 5 | 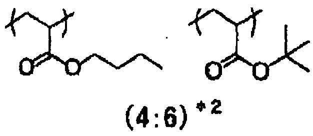 | 90 | 5.9 |
| P-19 | SB-2 | 1 | 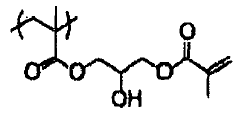 | 5 | 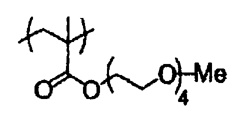 | 26 | 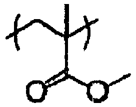 | 69 | 7.2 |
| P-20 | SB-2 | 1 | 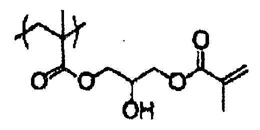 | 5 | 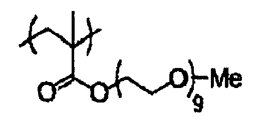 | 12 | 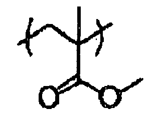 | 83 | 7.1 |
| P-21 | SB-2 | 1 | 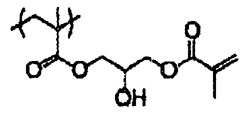 | 5 | 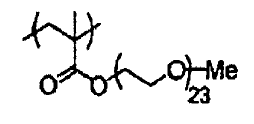 | 8 | 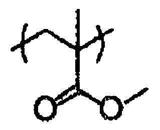 | 87 | 6.9 |
| P-22 | SB-2 | 1 | 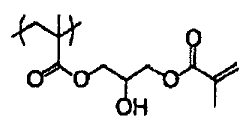 | 5 | 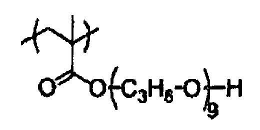 | 15 | 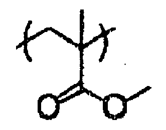 | 80 | 6.7 |
| P-23 | SB-2 | 1 | 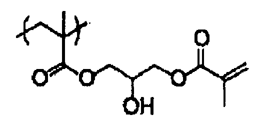 | 5 | 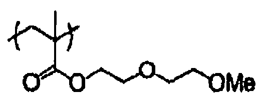 | 52 | 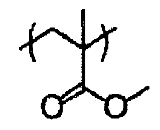 | 43 | 7.3 |

| | | | | | | | | | |
|---|---|---|---|---|---|---|---|---|---|
| * 1: A ratio of mole number (%) of SH group to the total mole number of the monomers. *2: A mole ratio of each unit is indicated in parentheses. | | | | | | | | | |

| Polymer No. | Central Nucleus | | Polymer Chain | | | | | | Mw (x 10⁴) |
|---|---|---|---|---|---|---|---|---|---|
| | No. | %by Mole* 1 | Polymerizable Group | % by Mole | Hydrophilic Group | % by Mole | Other | % by Mole | |
| P-24 | SB-1 | 1 | 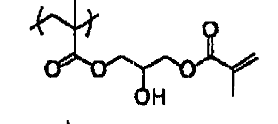 | 5 | 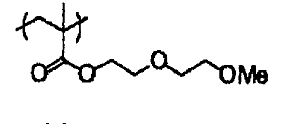 | 52 | 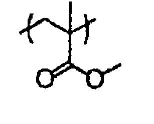 | 43 | 6.7 |
| P-25 | SB-3 | 1 | 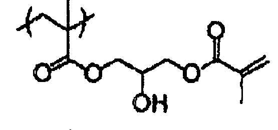 | 5 | 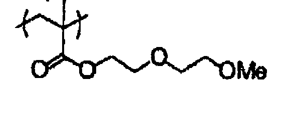 | 52 | 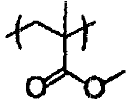 | 43 | 62 |
| P-26 | SB-4 | 1 | 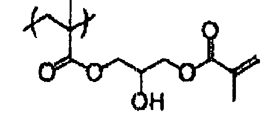 | 5 | 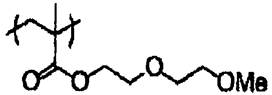 | 52 | 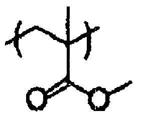 | 43 | 6.6 |
| P-27 | SB-5 | 1 | 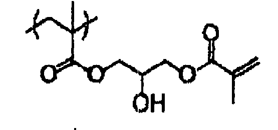 | 5 | 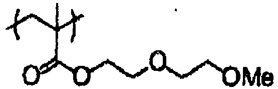 | 52 | 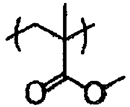 | 43 | 6.6 |
| P-28 | SB-6 | 1 | 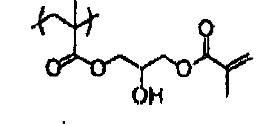 | 5 | 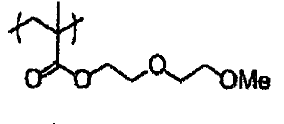 | 52 | 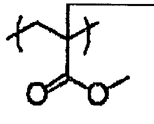 | 43 | 6.5 |
| P-29 | SB-7 | 0.6 | 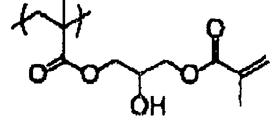 | 5 | 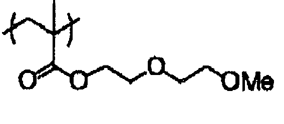 | 52 | 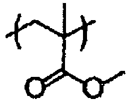 | 43 | 7.1 |
| P-30 | SB-8 | 0.6 | 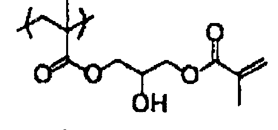 | 5 | 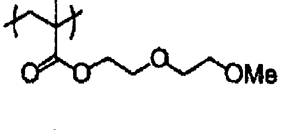 | 52 | 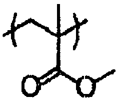 | 43 | 7.1 |
| P-31 | SB-9 | 0.6 | 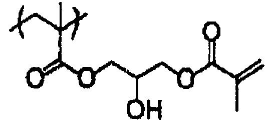 | 5 | 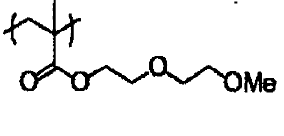 | 52 | 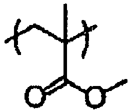 | 43 | 6.9 |
| P-32 | SB-10 | 0.6 | 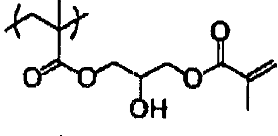 | 5 | 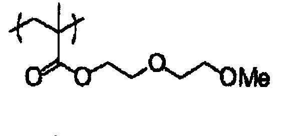 | 52 | 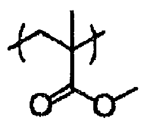 | 43 | 6.3 |
| P-33 | SB-11 | 0.6 | 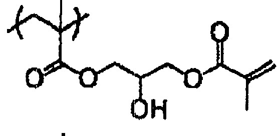 | 5 | 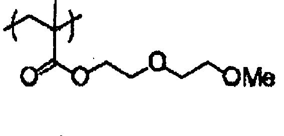 | 52 | 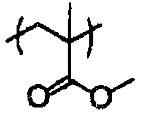 | 43 | 6.5 |
| P-34 | SB-12 | 0.6 | 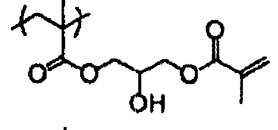 | 5 | 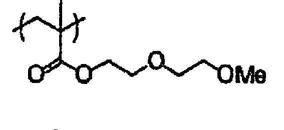 | 52 | 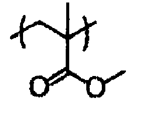 | 43 | 6.6 |
| P-35 | SB-14 | 1 | 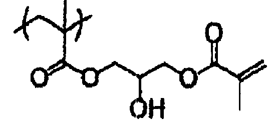 | 5 | 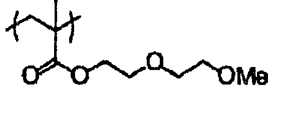 | 52 | 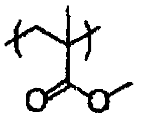 | 43 | 6.2 |
| P-36 | SB-15 | 1 | 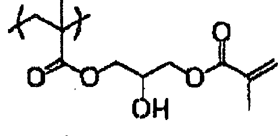 | 5 | 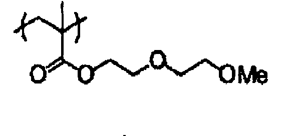 | 52 | 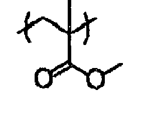 | 43 | 6.1 |
| P-37 | SB-16 | 1 | 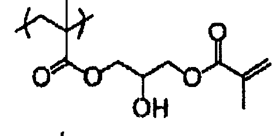 | 5 | 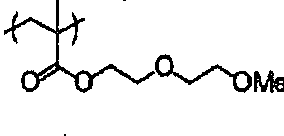 | 52 | 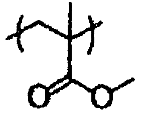 | 43 | 6.3 |
| P-38 | SB-17 | 1 | 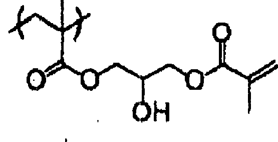 | 5 | 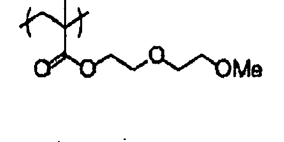 | 52 | 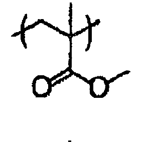 | 43 | 6.4 |
| P-39 | SB-20 | 1 | 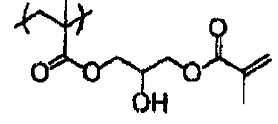 | 5 | 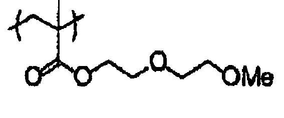 | 52 | 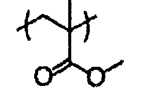 | . 43 | 6.3 |

| | | | | | | | | | |
|---|---|---|---|---|---|---|---|---|---|
| * 1: A ratio of mole number (%) of SH group to the total mole number of the monomers. | | | | | | | | | |

| Polymer No. | Central Nucleus | | Polymer Chain | | | | | | Mw (x 10⁴) |
|---|---|---|---|---|---|---|---|---|---|
| | No. | %by Mole* 1 | Polymerizable Group | %by Mole | Hydrophilic Group | %by Mole | Other | % by Mole | |
| P-40 | SB-26 | 1 | 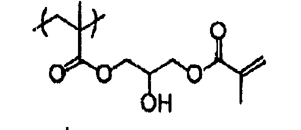 | 5 | 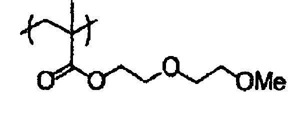 | 52 | 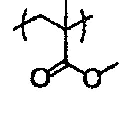 | 43 | 6.3 |
| P-41 | SB-32 | 1 | 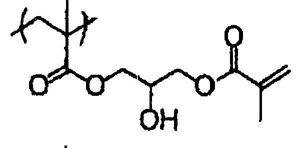 | 5 | 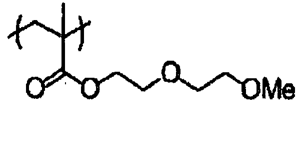 | 52 | 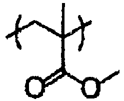 | 43 | 6.2 |
| P-42 | SB-38 | 1 | 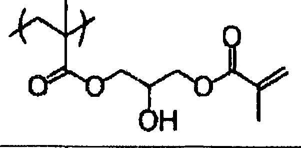 | 5 | 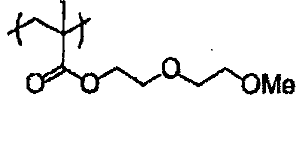 | 52 | 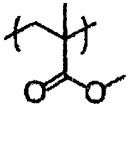 | 43 | 6.3 |
| P-43 | SB-37 | 1 | 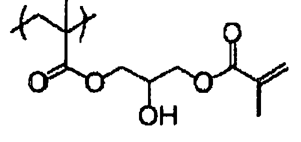 | 5 | 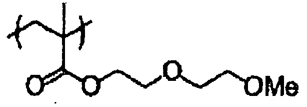 | 52 | 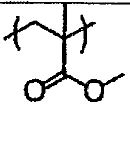 | 43 | 6.3 |
| P-44 | SC-1 | 1 | 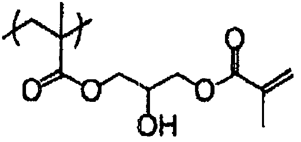 | 5 | 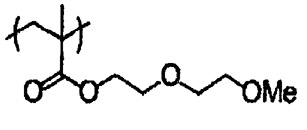 | 52 | 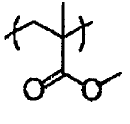 | 43 | 6.3 |
| P-45 | SC-2 | 1 | 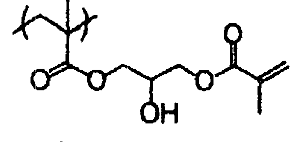 | 5 | 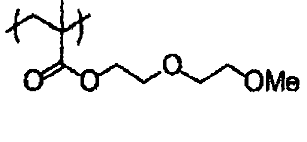 | 52 | 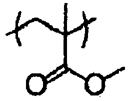 | 43 | 6.4 |
| P-46 | SC-4 | 1 | 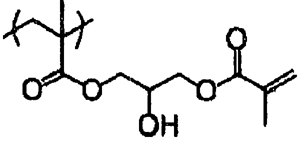 | 5 | 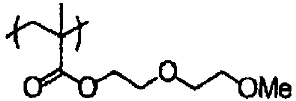 | 52 | 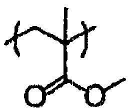 | 43 | 6.4 |
| P-47 | SC-5 | 1 | 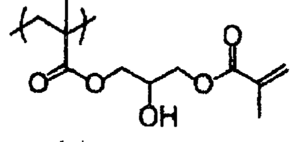 | 5 | 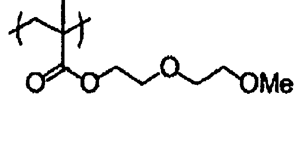 | 52 | 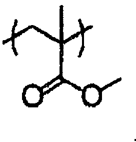 | 43 | 6.3 |
| P-48 | SD-2 | 0.8 | 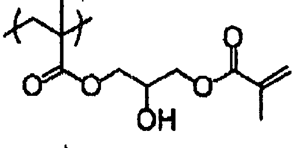 | 5 | 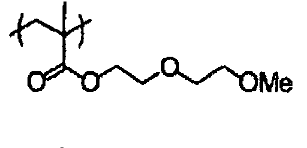 | 52 | 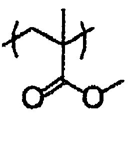 | 43 | 6.1 |
| P-49 | SD-3 | 0.8 | 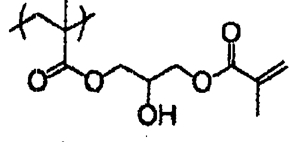 | 5 | 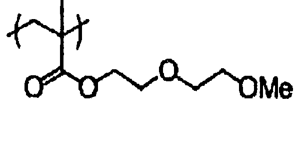 | 52 | 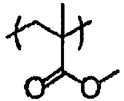 | 43 | 6.1 |
| P-50 | SD-4 | 0.8 | 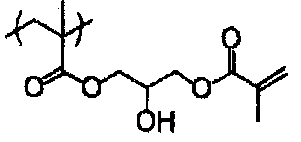 | 5 | 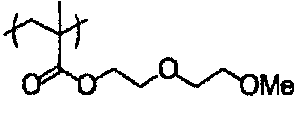 | 52 | 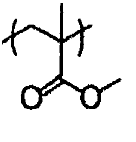 | 43 | 6.1 |
| P-51 | SD-5 | 0.8 | 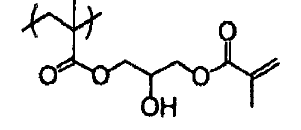 | 5 | 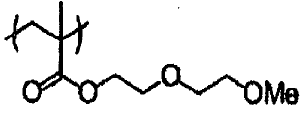 | 52 | 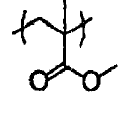 | 43 | 6.2 |

| | | | | | | | | | |
|---|---|---|---|---|---|---|---|---|---|
| *1: A ratio of mole number (%) of SH group to the total mole number of the monomers. | | | | | | | | | |

| Polymer No. | Central Nucleus | | Polymer Chain | | | | | | Mw (x 10⁴) |
|---|---|---|---|---|---|---|---|---|---|
| | No. | % by Mole*1 | Polymerizable Group | % by Mole | Hydrophilic Group | % by Mole | Other | % by Mole | |
| P-52 | SD-8 | 1 | 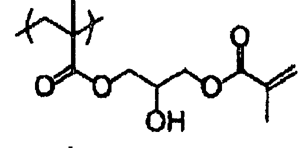 | 5 | 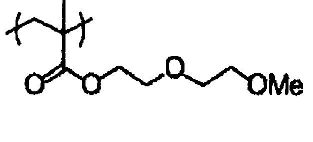 | 52 | 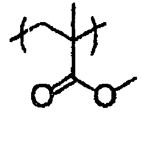 | 43 | 6.3 |
| P-53 | SD-14 | 1 | 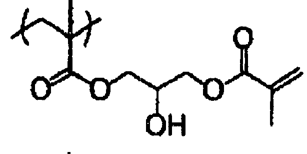 | 5 | 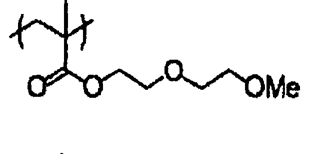 | 52 | 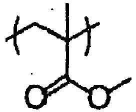 | 43 | 6.3 |
| P-54 | SA-1 | 1 | 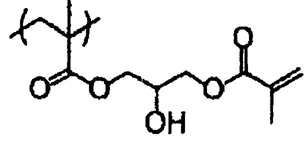 | 5 | 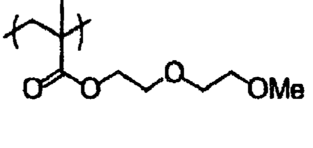 | 52 | 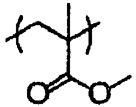 | 43 | 6.0 |
| P-55 | SA-2 | 0.6 | 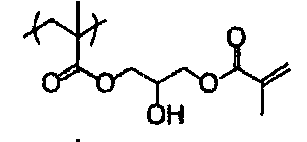 | 5 | 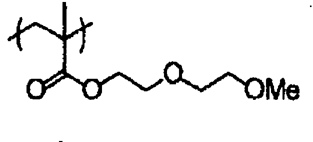 | 52 | 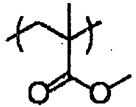 | 43 | 6.1 |
| P-56 | SA-3 | 1 | 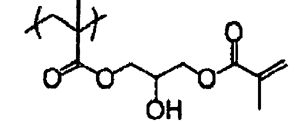 | 5 | 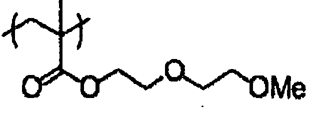 | 52 | 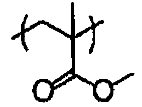 | 43 | 5.8 |
| P-57 | SE-2 | 1 | 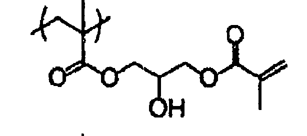 | 5 | 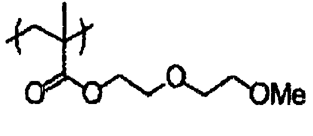 | 52 | 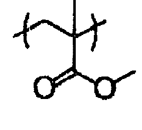 | 43 | 6.1 |
| P-58 | SE-3 | 1 | 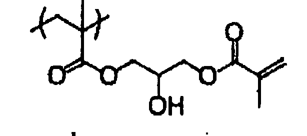 | 5 | 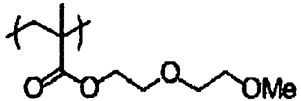 | 52 | 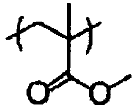 | 43 | 6.0 |
| P-59 | SE-5 | 1 | 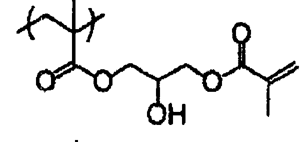 | 5 | 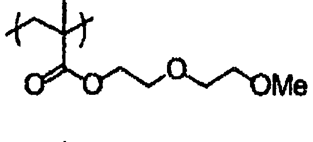 | 52 | 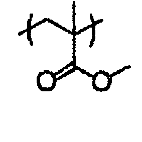 | 43 | 6.0 |
| P-60 | SE-6 | 1 | 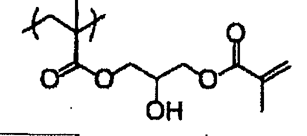 | 5 | 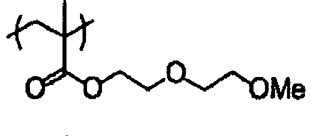 | 52 | 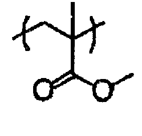 | 43 | 6.1 |
| P-61 | SE-7 | 1 | 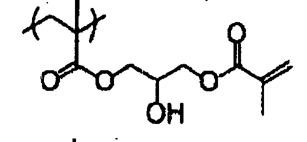 | 5 | 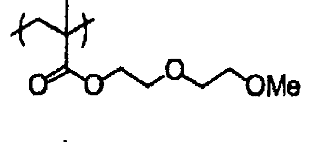 | 52 | 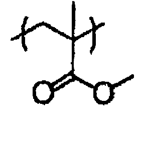 | 43 | 6.2 |
| P-62 | SE-9 | 1 | 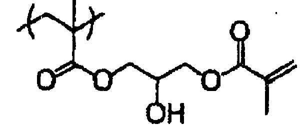 | 5 | 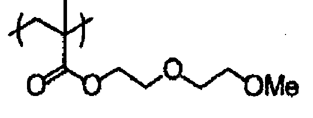 | 52 | 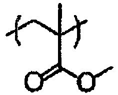 | 43 | 6.2 |
| P-63 | SF-1 | | 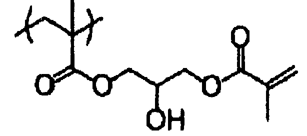 | 5 | 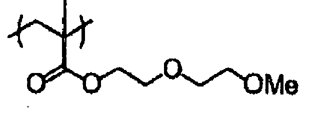 | 52 | 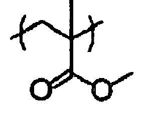 | 43 | 6.1 |

| | | | | | | | | | |
|---|---|---|---|---|---|---|---|---|---|
| *1: A ratio of mole number (%) of SH group to the total mole number of the monomer. | | | | | | | | | |

The star polymer according to the invention can be synthesized by a known method, for example, radical polymerization of the monomer constituting the polymer chain described above in the presence of the multifunctional thiol compound described above.

The weight average molecular weight (Mw) of the binder according to the invention is preferably from 5,000 to 500,000, more preferably from 10,000 to 250,000, and particularly preferably from 20,000 to 150,000. In the range described above, the development property and printing durability are more improved.

The binders according to the invention may be used only one kind or two or more kinds in combination. Also, it can be used together with a conventional straight-chain binder.

The content of the binder according to the invention in the image-recording layer is preferably from 5 to 95% by weight, more preferably from 10 to 90% by weight, particularly preferably from 15 to 85% by weight, based on the total solid content of the image-recording layer.

### <Radical polymerizable compound>

The radical polymerizable compound for use in the image-recording layer according to the invention is preferably an addition-polymerizable compound having at least one ethylenically unsaturated double bond and it is preferably selected from compounds having at least one, preferably two or more, terminal ethylenically unsaturated double bonds. The polymerizable compound has a chemical form, for example, a monomer, a prepolymer, specifically, a dimer, a trimer or an oligomer, or a mixture thereof. Examples of the monomer include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with a polyhydric alcohol compound and amides of an unsaturated carboxylic acid with a polyvalent amine compound are used. An addition reaction product of an unsaturated carboxylic acid ester or amide having a nucleophilic substituent, for example, a hydroxy groups, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used. These compounds are described in references including JP-T-2006-508380 (the term "JP-T" as used herein means a published Japanese translation of a PCT patent application), JP-A-2002-287344, JP-A-2008-256850, JP-A-2001-342222, JP-A-9-179296, JP-A-9-179297, JP-A-9-179298, JP-A-2004-294935, JP-A-2006-243493, JP-A-2002-275129, JP-A-2003-64130, JP-A-2003-280187 and JP-A-10-333321.

Specific examples of the monomer, which is an ester of a polyhydric alcohol compound with an unsaturated carboxylic acid, include, as an acrylic acid ester, for example, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO) modified triacrylate and polyester acrylate oligomer. As a methacrylic acid ester, for example, tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane and bis[p-(methacryloxyethoxy)phenyl]dimethylmethane are exemplified. Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Urethane type addition-polymerizable compounds produced using an addition reaction between an isocyanate and a hydroxy group are also preferably used and specific examples thereof include vinylurethane compounds having two or more Polymerizable vinyl groups per molecule obtained by adding a vinyl monomer containing a hydroxy group represented by formula (A) shown below to a polyisocyanate compound having two or more isocyanate groups per molecule, described in JP-B-48-41708 (the term "JP-B" as used herein means an "examined Japanese patent publication").

CH₂=C(R⁴)COOCH₂CH(R⁵)OH (A)

wherein R⁴ and R⁵ each independently represents H or CH₃.

Also, urethane acrylates as described in JP-A-51-37193, JP-B-2-32293, JP-B-2-16765, JP-A-2003-344997 and JP-A-2006-65210, urethane compounds having an ethylene oxide skeleton described in JP-B-58-49860, JP-B-56-17654, JP-B-62-39417, JP-B-62-39418, JP-A-2000-250211 and JP-A-2007-94138, and urethane compounds having a hydrophilic group described in U.S. Patent 7,153,632, JP-T-8-505958, JP-A-2007-293221 and JP-A-2007-293223 are preferably used.

Of the compounds described above, an isocyanuric acid ethyleneoxide-modified acrylate, for example, tris(acryloyloxyethyl) isocyanurate or bis(acryloyloxyethyl) hydroxyethyl isocyanurate is particularly preferred from the standpoint of excellent balance between hydrophilicity relating to the on-press development property and polymerization ability relating to the printing durability.

Details of the method of using the polymerizable compound, for example, selection of the structure, individual or combination use or an amount added, can be appropriately determined in accordance with the characteristic design of the final lithographic printing plate precursor. The polymerizable compound is used preferably in a range from 5 to 75% by weight, more preferably in a range from 10 to 70% by weight, particularly preferably in a range from 15 to 60% by weight, based on the total solid content of the image-recording layer.

### <Radical polymerization initiator>

The radical polymerization initiator for use in the invention is a compound which initiates or accelerates polymerization of the radical polymerizable compound. The radical polymerization initiator for use in the invention includes, for example, known thermal polymerization initiators, compounds containing a bond having small bond dissociation energy and photopolymerization initiators. Among them, photopolymerization initiators are preferred.

The radical polymerization initiator according to the invention include, for example, (a) an organic halide, (b) a carbonyl compound, (c) an azo compound, (d) an organic peroxide, (e) a metallocene compound, (f) an azido compound, (g) a hexaarylbiimidazole compound, (h) an organic borate salt compound, (i) a disulfone compound, (j) an oxime ester compound, (k) an onium salt compound and (l) a carboxylic acid-based compound.

As the organic halide (a), compounds described in Paragraph Nos. [0022] to [0023] of JP-A-2008-195018 are preferred.

As the carbonyl compound (b), compounds described in Paragraph No. [0024] of JP-A-2008-195018 are preferred.

As the azo compound (c), for example, azo compounds described in JP-A-8-108621 are used.

As the organic peroxide (d), for example, compounds described in Paragraph No. [0025] of JP-A-2008-195018 are preferred.

As the metallocene compound (e), for example, compounds described in Paragraph No. [0026] of JP-A-2008-195018 are preferred.

As the azido compound (f), a compound, for example, 2,6-bis(4-azidobenzylidene)-4-methylcyclohexanone is exemplified.

As the hexaarylbiimidazole compound (g), for example, compounds described in Paragraph No. [0027] of JP-A-2008-195018 are preferred.

As the organic borate salt compound (h), organic borate salt compounds capable of generating a radical upon decomposition with light or heat, for example, compounds described in Paragraph No. [0028] of JP-A-2008-195018 are preferred.

As the disulfone compound (i), for example, compounds described in JP-A-61-166544 are exemplified.

As the oxime ester compound (j), for example, compounds described in Paragraph Nos. [0028] to [0030] of JP-A-2008-195018 are preferred.

As the onium salt compound (k), onium salts capable of generating a radical upon decomposition with light or heat, for example, diazonium salts described in S. I. Schlesinger, Photorgr. Sci. Eng., 18, 387 (1974), T. S. Bal et al., Polymer, 21, 423 (1980) and JP-A-5-158230, ammonium salts described in U.S. Patent 4,069,055 and JP-A-4-365049, phosphonium salts described in U.S. Patents 4,069,055 and 4,069,056, iodonium salts described in European Patent 104,143, U. S. Patent Publication No. 2008/0311520, JP-A-2-150848, JP-A-2008-195018 and J. V. Crivello et al., Macromolecules, 10 (6), 1307 (1977), sulfonium salts described in European Patents 370,693, 233,567, 297,443 and 297,442, U.S. Patents 4,933,377, 4,760,013, 4,734,444 and 2,833,827 and German Patents 2,904,626,3,604,580 and 3,604,581, selenonium salts described in J. V. Crivello et al., J. Polymer Sci., Polymer Chem. Ed., 17, 1047 (1979), arsonium salts described in C. S. Wen et al., Teh, Proc. Conf. Rad. Curing ASIA, p. 478, Tokyo, Oct. (1988), and azinium salts described in JP-A-2008-195018 are exemplified.

As the carboxylic acid-based compound (1), for example, compounds described in Paragraph Nos. [0118] to [0164] of U.S. Patent Publication No. 2003/0118939, Paragraph Nos. [0065] to [0068] of U.S. Patent Publication No. 2004/0091811, Paragraph Nos. [0114] to [0162] of U.S. Patent Publication No. 2004/0259027 and Paragraph Nos. [0071] to [0115] of JP-A-2005-059446 are exemplified.

Of the radical polymerization initiators above, the hexaarylbiimidazole compound (g), organic borate salt compound (h), onium salt compound (k) or carboxylic acid-based compound (l) is preferred, the organic borate salt compound (h), onium salt compound (k) or carboxylic acid-based compound (l) is more preferred, and the onium salt compound (k) is particularly preferred. Of the onium salt compounds, the iodonium salt, sulfonium salt or azinium salt is preferred.

The radical polymerization initiators may be used individually only one kind or in combination of two or more kinds thereof. In the case of using in combination of two or more kinds thereof, it is preferred to use the onium salt compound (k) together with the organic borate salt compound (h) or carboxylic acid-based compound (l). In the case of using the onium salt compound (k) together with the organic borate salt compound (h), a compound of ion pair formed from both compounds can also be preferably used.

Specific examples of these compounds are set forth below, but the invention should not be construed as being limited thereto.

The hexaarylbiimidazole compound includes, for example,
2,2'-bis(o-chlorophenyl)-4,4',5,5'-tetraphenylbiimidazole,
2,2'-bis(o-bromophenyl)-4,4',5,5'-tetraphenylbiimidazole,
2,2'-bis(o,p-dichlorophenyl)-,4',5,5'-tetraphenylbiimidazole,
2,2'-bis(o-chlorophenyl)-4,4',5,5'-tetra(m-methoxyphenyl)biimidazole,
2,2'-bis(o,o'-dichlorophenyl)-4,4',5,5'-tetraphenylbiimidazole,
2,2'-bis(o-nitrophenyl)-4,4',5,5'-tetraphenylbiimidazole,
2,2'-bis(o-methylphenyl)-4,4',5,5'-tetraphenylbiimidazole and
2,2'-bis(o-trifluoromethylphenyl)-4,4',5,5'-tetraphenylbiimidazole. The hexaarylbiimidazole compound is particularly preferably used together with a sensitizing dye having an absorption maximum in a wavelength range from 300 to 450 nm.

Of the iodonium salts, a diphenyliodonium salt is preferred. In particular, a diphenyliodonium salt substituted with an electron donating group, for example, an alkyl group or an alkoxy group is preferred, and an asymmetric diphenyliodonium salt is more preferred. Specific examples of the iodonium salt include diphenyliodonium hexafluorophosphate,

4-methoxyphenyl-4-(2-methylpropyl)phenyliodonium hexafluorophosphate,
4-(2-methylpropyl)phenyl-p-tolyliodonium hexafluorophosphate,
4-hexyloxyphenyl-2,4,6-trimethoxyphenyliodonium hexafluorophosphate,
4-hexyloxyphenyl-2,4-diethoxyphenyliodonium tetrafluoroborate,
4-ocryloxyphenyl-2,4,6-trimethoxyphenyliodonium 1-perfluorobutanesulfonate,
4-octyloxyphenyl-2,4,6-trimethoxyphenyliodonium hexafluorophosphate and
bis(4-tert-butylphenyl)iodonium tetraphenylborate.

Examples of the sulfonium salt include triphenylsulfonium hexafluorophosphate, triphenylsulfonium benzoylformate, bis(4-chlorophenyl)phenylsulfonium benzoylformate, bis(4-chlorophenyl)-4-methylphenylsulfonium tetrafluoroborate, tris(4-chlorophenyl)sulfonium 3,5-bis(methoxycarbonyl)benzenesulfonate and tris(4-chlorophenyl)sulfonium hexafluorophosphate.

Examples of the azinium salt include 1-cyclohexylmethyloxypyridinium hexafluorophosphate, 1-cyclohexyloxy-4-phenylpyridinium hexafluorophosphate, 1-ethoxy-4-phenylpyridinium hexafluorophosphate, 1-(2-ethythexyloxy)-4-phenylpyridinium hexafluorophosphate, 4-chloro-1-cyclohexylmethyloxypyridinium hexafluorophosphate, 1-ethoxy-4-cyanopyridinium hexafluorophosphate, 3,4-dichloro-1-(2-ethylhexyloxy)pyridinium hexafluorophosphate, 1-ben2yloxy-4-phenylpyridinium hexafluorophosphate, 1-phenethyloxy-4-phenylpyridinium hexafluorophosphate, 1-(2-ethylhexyloxy)-4-phenylpyridinium p-toluenesulfonate, 1-(2-ethylhexyloxy)-4-phenylpyridinium perfluorobutanesulfonate, 1-(2-ethylhexyloxy)-4-phenylpyridinium bromide and 1-(2-ethylhexyloxy)-4-phenylpyridinium tetrafluoroborate.

Examples of the organic borate salt compound include tetraphenyl borate salt, tetratolyl borate salt, tetrakis(4-methoxyphenyl) borate salt, tetrakis(pentafluorophenyl) borate salt, tetrakis(3,5-bis(trifluoromethyl)phenyl) borate salt, tetrakis(4-chlorophenyl) borate salt, tetrakis(4-fluorophenyl) borate salt, tetrakis(2-thienyl) borate salt, tetrakis(4-methoxyphenyl) borate salt, tetrakis(4-phenylphenyl) borate salt, tetrakis(4-tert-butylphenyl) borate salt, ethyl triphenyl borate salt and butyl triphenyl borate salt. As a counter cation of the borate salt, a known cation, for example, an alkali metal cation, an alkaline earth metal cation, an ammonium cation, a phosphonium cation, a sulfonium cation, iodonium cation a diazonium cation or an azinium cation is exemplified.

Examples of the carboxylic acid-based compound include N-phenyliminidiacetic acid, (p-acetamidophenylimino)diacetic acid, 4-[bis(carboxymethyl)amino]benzoic acid, 3-[bis(carboxymethyl)amino]-2-naphthalenecarboxylic acid, N,N'-1,3-phenylenebisglycine, N,N'-1,3-phenylenebis[N-(carboxymethyl)]glycine, N,N'-1,2-phenylenebis[N-(carboxymethyl)]glycine, N-(carboxymethyl)-N-(4-methoxyphenyl)glycine,N-(carboxymethyl)-N-(3-methoxyphenyl)glycine, N-(carboxymethyl)-N-(3-hydroxyphenyl)glycine, N-(carboxymethyl)-N-(4-bromophenyl)glycine, N-(carboxymethyl)-N-(4-chlorophenyl)glycine, N-(carboxymethyl)-N-(4-ethylphenyl)glycine, N-(carboxymethyl)-N-(3,4-dimethylphenyl)glycine, N-(carboxymethyl}-N-(3,5-dimethylphenyl)glycine, N-(carboxymethyl)-N-(2,6-dimethylphenyl)glycine, N-(carboxymethyl)-N-methylglycine, N,N-diphenylglycine, N-phenyl-N-(phenylaminocarbonylmethyl)glycine, N-phenyl-N-(ethoxycarbonylinethyl)glycine, N-(3,4,5-trimethoxyphenyl)-N-(methoxycarbonylmethyl)glycine, N-(4-dimethylaminophenyl)-N-(methoxycarbonylmethyl)glycine, N-(carboxymethyl)-N-ethylanthranilic acid, N-(2-carboxyphenyl)glycine, o-dianisidine-N,N,N',N'-tetraacetic acid, N,N'-(1,2-ethanediylbis(oxy-2,1-phenylene)bis-N-(carboxymethyl)glycine), 4-carboxyphenoxyacelic acid, catechol-O,O'-diacetic acid, 4-methylcatechol-O,O'-diacetic acid, resorcinol-O,O'-diacetic acid, hydroquinone-O,O'-diacetic acid, 4,4'-isopropylidenediphenoxyacetic acid, 2-(carboxymethylthio)benzoic acid, 3-[(carboxymethyl)thio-2-naphthalenecarboxylic acid, N-phenylglycine, (2-methoxyphenoxy)acetic acid, phenoxyacetic acid, (3,4-dimethoxyphenylthio)acetic acid, indole-3-acetic acid, 4-dimethylaminophenylacetic acid, phenylthioacetic acid, N-methylindole-3-acetic acid and 4-dimethylaminophenylacetic acid.

The onium salt is particularly preferably used together with an infrared absorbing agent having an absorption maximum in a wavelength range from 750 to 1,400 nm.

The radical polymerization initiator can be added preferably in an amount from 0.1 to 50% by weight, more preferably from 0.5 to 30% by weight, particularly preferably from 0.8 to 20% by weight, based on the total solid content constituting the image-recording layer. In the range described above, good sensitivity and good stain resistance in the non-image area at the time of printing are obtained.

### <Other compounds>

Further, the image-recording layer can also contain the compounds described below as other additives.

### <Sensitizing dye>

The sensitizing dye for use in the image-recording layer is not particularly restricted as far as it absorbs light at the image exposure to form the excited state and provides energy to the polymerization initiator described above with electron transfer, energy transfer or heat generation thereby improving the polymerization initiation function. In particular, a sensitizing dye having an absorption maximum in a wavelength range from 300 to 450 nm or from 750 to 1,400 nm is preferably used.

Examples of the sensitizing dye having an absorption maximum in a wavelength range from 300 to 450 nm include a merocyanine, a benzopyran, a coumarin, an aromatic ketone, an anthracene, a styryl and an oxazole.

Of the sensitizing dyes having an absorption maximum in a wavelength range from 300 to 450 nm, a dye represented by formula (IX) shown below is more preferred in view of high sensitivity.

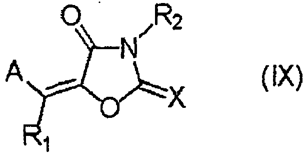

In formula (IX), A represents an aryl group which may have a substituent or a heteroaryl group which may have a substituent, X represents an oxygen atom, a sulfur atom or =N(R₃), and R₁, R₂ and R₃ each independently represents a monovalent non-metallic atomic group, or A and R₁ or R₂ and R₃ may be combined with each other to form an aliphatic or aromatic ring.

The formula (IX) will be described in more detail below. The monovalent non-metallic atomic group represented by any one of R₁, R₂ and R₃ preferably represents a hydrogen atom, a substituted or unsubstituted alkyl group, a substituted or unsubstituted alkenyl group, a substituted or unsubstituted aryl group, a substituted or unsubstituted heteroaryl group, a substituted or unsubstituted alkoxy group, a substituted or unsubstituted alkylthio group, a hydroxy group or a halogen atom.

Specific examples of the sensitizing dye preferably used include compounds described in Paragraph Nos. [0047] to [0053] of JP-A-2007-58170, Paragraph Nos. [0036] to [0037] of JP-A-2007-93866 and Paragraph Nos. [0042] to [0047] of JP-A-2007-72816.

Further, sensitizing dyes described in JP-A-2006-189604, JP-A-2007-171406, JP-A-2007-206216, JP-A-2007-206217, JP-A-2007-225701, JP-A-2007-225702, JP-A-2007-316582 and JP-A-2007-328243 are also preferably used.

Next, the sensitizing dye having an absorption maximum in a wavelength range from 750 to 1,400 (hereinafter, also referred to as an "infrared absorbing agent") is described below. The infrared absorbing agent used is preferably a dye or a pigment

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred, As particularly preferable examples of the dye, cyanine dyes represented by formula (a) shown below are exemplified.

### Formula (a):

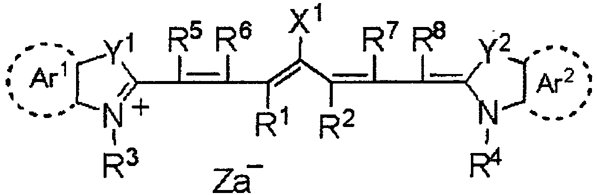

In formula (a), X¹ represents a hydrogen atom, a halogen atom, -X²-L¹ or a group shown below. X² represents an oxygen atom, -NL²- or a sulfur atom, L¹ and L² each represents a hydrocarbon group having from 1 to 12 carbon atoms, an aryl group, an aryl group containing a hetero atom (a nitrogen atom, a sulfur atom, an oxygen atom, a halogen atom or a selenium atom) or a hydrocarbon group having from 1 to 12 carbon atoms and containing a hetero atom.

In the group shown below, Xa⁻ has the same meaning as Za⁻ defined hereinafter. R^{a} represents a hydrogen atom or a substituent selected from an alkyl group, an aryl group, a substituted or unsubstituted amino group and a halogen atom.

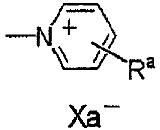

R¹ and R² each independently represents a hydrocarbon group having from 1 to 12 carbon atoms. In view of the preservation stability of a coating solution for image-recording layer, it is preferred that R¹ and R² each represent a hydrocarbon group having two or more carbon atoms. Also, R¹ and R² may be combined with each other to form a ring and in case of forming the ring, to form a 5-membered or 6-membered ring is particularly preferred.

Ar¹ and Ar², which may be the same or different, each represents an aryl group which may have a substituent. Preferable examples of the aryl group include a benzene ring group and a naphthalene ring group. Preferable examples of the substituent include a hydrocarbon group having 12 or less carbon atoms, a halogen atom and an alkoxy group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms, which may have a substituent, Preferable examples of the substituent include an alkoxy group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms. From the standpoint of the availability of raw materials, a hydrogen atom is preferred. Za⁻ represents a counter anion. However, Za⁻ is not necessary when the cyanine dye represented by formula (a) has an anionic substituent in the structure thereof and the neutralization of charge is not needed. Preferable examples of the counter ion for Za⁻ include a halide ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion in view of the preservation stability of a coating solution for image-recording layer.

Specific examples of the cyanine dye represented by formula (a) include compounds described in Paragraph Nos. [0017] to [0019] of JP-A-2001-133969, Paragraph Nos. [0016] to [0021] of JP-A-2002-23360 and Paragraph Nos. [0012] to [0037] of JP-A-2002-40638, preferably compounds described in Paragraph Nos. [0034] to [0041] of JP-A-2002-278057 and Paragraph Nos. [0080] to [0086] of JP-A-2008-195018, and particularly preferably compounds described in Paragraph Nos. [0035] to [0043] of JP-A-2007-90850.

Further, compounds described in Paragraph Nos. [0008] to [0009] of JP-A-5-5005 and Paragraph Nos. [0022] to [0025] of JP-A-2001-222101 are also preferably used.

The infrared absorbing dyes may be used only one kind or in combination of two or more kinds thereof and may be used together with an infrared absorbing agent other than the infrared absorbing dye, for example, a pigment As the pigment, compounds described in Paragraph Nos. [0072] to [0076] of JP-A-2008-195018 are preferred.

The content of the sensitizing dye is preferably from 0.05 to 30 parts by weight, more preferably from 0.1 to 20 parts by weight, particularly preferably from 0.2 to 10 parts by weight, per 100 parts by weight of the total solid content of the image-recording layer.

### <Hydrophobilizing precursor>

The image-recording layer may contain a hydrophobilizing precursor in order to improve the development property or on-press development property. The hydrophobilizing precursor means a fine particle capable of converting the image-recording layer to be hydrophobic when heat and/or light is applied. The fine particle is preferably at least one fine particle selected from hydrophobic thermoplastic polymer fine particle, thermo-reactive polymer fine particle, polymer fine particle having a polymerizable group, microcapsule having a hydrophobic compound encapsulated and microgel (crosslinked polymer fine particle). Among them, polymer fine particle having a Polymerizable group and microgel are preferred.

As the hydrophobic thermoplastic polymer fine particle, hydrophobic thermoplastic polymer fine particles described, for example, in Research Disclosure, No. 33303, January (1992), JP-A-9-123387, JP-A-9-131850, JP-A-9-171249, JP-A-9-171250 and European Patent 931,647 are preferably exemplified.

Specific examples of the polymer constituting the polymer fine particle include a homopolymer or copolymer of a monomer, for example, ethylene, styrene, vinyl chloride, methyl acrylate, ethyl acrylate, methyl methacrylate, ethyl methacrylate, vinylidene chloride, acrylonitrile, vinyl carbazole or an acrylate or methacrylate having a polyalkylene structure and a mixture thereof. Among them, polystyrene, a copolymer containing styrene and acrylonitrile and polymethyl methacrylate are more preferred.

The average particle size of the hydrophobic thermoplastic polymer fine particle for use in the invention is preferably from 0.01 to 2.0 µm.

The thermo-reactive polymer fine particle for use in the invention includes polymer fine particle having a thermo-reactive group and forms a hydrophobilized region by crosslinkage due to thermal reaction and change in the functional group involved therein.

As the thermo-reactive group of the polymer fine particle having a thermo-reactive group for use in the invention, although a functional group performing any reaction can be used as long as a chemical bond is formed, a polymerizable group is preferred. For instance, an ethylenically unsaturated group (for example, an acryloyl group, a methacryloyl group, a vinyl group or an allyl group) performing a radical polymerization reaction, a cationic polymerizable group (for example, a vinyl group, a vinyloxy group, an epoxy group or an oxetanyl group), an isocyanate group performing an addition reaction or a blocked form thereof, an epoxy group, a vinyloxy group and a functional group having an active hydrogen atom (for example, an amino group, a hydroxy group or a carboxyl group) as the reaction partner thereof, a carboxyl group performing a condensation reaction and a hydroxyl group or an amino group as the reaction partner thereof, and an acid anhydride performing a ring opening addition reaction and an amino group or a hydroxyl group as the reaction partner thereof are preferably exemplified.

As the microcapsule for use in the invention, microcapsule having all or part of the constituting components of the image-recording layer encapsulated as described, for example, in JP-A-2001-277740 and JP-A-2001-277742 is exemplified. The constituting components of the image-recording layer may be present outside the microcapsules. It is a more preferred embodiment of the image-recording layer containing microcapsules that the hydrophobic constituting components are encapsulated in microcapsules and the hydrophilic components are present outside the microcapsules.

The microgel for use in the invention can contain a part of the constituting components of the image-recording layer at least one of in the inside and on the surface thereof. In particular, an embodiment of a reactive microgel containing a radical Polymerizable group on the surface thereof is preferred in view of the image-forming sensitivity and printing durability.

In order to conduct microencapsulation or microgelation of the constituting component of the image-recording layer, known methods can be used.

The average particle size of the microcapsule or microgel is preferably from 0.01 to 3.0 µm, more preferably from 0.05 to 2.0 µm, particularly preferably from 0.10 to 1.0 µm. In the range described above, good resolution and good time lapse stability can be achieved.

The content of the hydrophobilizing precursor is preferably from 5 to 90% by weight based on the total solid content of the image-recording layer.

### <Oil-sensitizing agent>

In order to improve the ink receptivity, an oil-sensitizing agent, for example, a phosphonium compound, a nitrogen-containing low molecular weight compound or an ammonium group-containing polymer can be used in the image-recording layer according to the invention. In particular, in the case where an inorganic stratiform compound is incorporated into a protective layer described hereinafter, the oil-sensitizing agent functions as a surface covering agent of the inorganic stratiform compound and prevents deterioration of the ink receptivity during printing due to the inorganic stratiform compound.

As preferable examples of the phosphonium compound, phosphonium compounds described in JP-A-2006-297907 and JP-A-2007-50660 are exemplified. Specific examples of the phosphonium compound include tetrabutylphosphonium iodide, butyltriphenylphosphonim bromide, tetraphenylphosphonium bromide, 1,4-bis(triphenylphosphonio)butane di(hexafluorophosphate), 1,7-bis(triphenylphosphonio)heptane sulfate and 1,9-bis(triphenylphosphonio)nonane naphthalene-2,7-disulfonate.

As the nitrogen-containing low molecular weight compound, an amine salt and a quaternary ammonium salt are exemplified. Also, an imidazolinium salt, a benzimidazolinium salt, a pyridinium salt and a quinolinium salt are exemplified. Of the nitrogen-containing low molecular weight compounds, the quaternary ammonium salt and pyridinium salt are preferably used. Specific examples the nitrogen-containing low molecular weight compound include tetramethylammonium hexafluorophosphate, tetrabutylammonium hexafluorophosphate, dodecyltrimethylammonium p-toluenesulfonate, benzyltriethylammonium hexafluorophosphate, benzyldimethyloctylammonium hexafluorophosphate, benzyldimethyldodecylammonium hexafluorophosphate and compounds described in Paragraph Nos. [0021] to [0037] of JP-A-2008-284858 and Paragraph Nos. [0030] to [0057] of JP-A-2009-90645.

The ammonium group-containing polymer may be any polymer containing an ammonium group in its structure and is preferably a polymer containing from 5 to 80% by mole of (meth)acrylate having an ammonium group in its side chain as a copolymerization component. Specific examples thereof include polymers described in Paragraph Nos. [0089] to [0105] of JP-A-2009-208458.

As to the ammonium group-containing polymer, its reduced specific viscosity value (unit: ml/g) determined according to the measuring method described in Paragraph No. [0085] of JP-A-2009-208458 is preferably in a range from 5 to 120, more preferably in a range from 10 to 110, particularly preferably in a range from 15 to 100. When the reduced specific viscosity value described above is calculated in terms of weight average molecular weight (Mw), from 10,000 to 150,000 is preferred, from 17,000 to 140,000 is more preferred, and 20,000 to 130,000 is particularly preferred.

Specific examples of the ammonium group-containing polymer are set forth below.
(1) 2-(Trimethylammonio)ethyl methacrylate p-toluenesulfonate/3,6-dioxaheptyl methacrylate copolymer (molar ratio: 10/90, Mw: 45,000)
(2) 2-(Trimethylammonio)ethyl methacrylate hexafluorophosphate /3,6-dioxaheptyl methacrylate copolymer (molar ratio: 20/80, Mw: 60,000)
(3) 2-(Ethyldimethylammonio)ethyl methacrylate p-toluenesulfonate/hexyl methacrylate copolymer (molar ratio: 30/70, Mw: 45,000)
(4) 2-(Trimethylammonio)ethyl methacrylate hexafluorophosphate /2-ethylhexyl methacrylate copolymer (molar ratio: 20/80, Mw: 60,000)
(5) 2-(Trimethylammonio)ethyl methacrylate methylsulfate/hexyl methacrylate copolymer (molar ratio: 40/60, Mw: 70,000)
(6) 2-(Butyldimethylammonio)ethyl methacrylate hexafluorophosphate/3,6-dioxaheptyl methacrylate copolymer (molar ratio: 25/75, Mw: 65,000)
(7) 2-(Butyldimethylammonio)ethyl acrylate hexafluorophosphate/3,6-dioxaheptyl methacrylate copolymer (molar ratio: 20/80, Mw: 65,000)
(8) 2-(Butyldimethylammonio)ethyl methacrylate 13-ethyl-5,8,11-trioxa-1-heptadecanesulfonate/3,6-dioxaheptyl methacrylate copolymer (molar ratio: 20/80, Mw: 75,000)
(9) 2-(Butyldimethylammonio)ethyl methacrylate hexafluorophosphate/3,6-dioxaheptyl methacrylate/2-hydroxy-3-methacryloyloxypropyl methacrylate copolymer (molar ratio: 15/80/5, Mw: 65,000)

The content of the oil-sensitizing agent is preferably from 0.01 to 30.0% by weight, more preferably from 0.1 to 15.0% by weight, still more preferably from 1 to 10% by weight, based on the total solid content of the image-recording layer.

### <Hydrophilic low molecular weight compound>

The image-recording layer according to the invention may contain a hydrophilic low molecular weight compound in order to improve the on-press development property without accompanying the decrease in the printing durability.

The hydrophilic low molecular weight compound includes a water-soluble organic compound, for example, a glycol compound, e.g., ethylene glycol, diethylene glycol, triethylene glycol, propylene glycol, dipropylene glycol or tripropylene glycol, or an ether or ester derivative thereof, a polyol compound, e.g., glycerine, pentaerythritol or tris(2-hydroxyethyl) isocyanurate, an organic amine compound, e.g., triethanol amine, diethanol amine or monoethanol amine, or a salt thereof, an organic sulfonic acid compound, e.g., an alkyl sulfonic acid, toluene sulfonic acid or benzene sulfonic acid, or a salt thereof, an organic sulfamic acid compound, e.g., an alkyl sulfamic acid, or a salt thereof, an organic sulfuric acid compound, e.g., an alkyl sulfuric acid or an alkyl ether sulfuric acid, or a salt thereof, an organic phosphonic acid compound, e.g., phenyl phosphonic acid, or a salt thereof, an organic carboxylic acid, e.g., tartaric acid, oxalic acid, citric acid, malic acid, lactic acid, gluconic acid or an amino acid, or a salt thereof and a betaine compound.

According to the invention, it is preferred to incorporate at least one compound selected from a polyol compound, an organic sulfate compound, an organic sulfonate compound and a betaine compound into the image-recording layer.

Specific examples of the organic sulfonate compound include an alkylsulfonate, for example, sodium butylsulfonate, sodium hexylsulfonate, sodium 2-ethylhexylsulfonate, sodium cyclohexylsulfonate or sodium octylsulfonate; an alkylsulfonate containing an ethylene oxide chain, for example, sodium 5,8,11-trioxapentadecane-1-sulfonate, sodium 5,8,11-trioxaheptadecane-1-sulfonate, sodium 13-ethyl-5,8,11-trioxaheptadecane-1-sulfonate or sodium 5,8,11,14-telraoxatetracosane-1-sulfonate; an arylsulfonate, for example, sodium benzenesulfonate, sodium p-toluenesulfonate, sodium p-hydroxybenzenesulfonate, sodium p-styrenesulfonate, sodium isophthalic acid dimethyl-5-sulfonate, sodium 1-naphtylsulfonate, sodium 4-hydroxynaphtylsulfonate, disodium 1,5-naphthalenedisulfonate or trisodium 1,3,6-naphthalenetrisulfonate, and compounds described in Paragraph Nos. [0026] to [0031] of JP-A-2007-276454 and Paragraph Nos. [0020] to [0047] of JP-A-2009-154525. The salt may also be potassium salt or lithium salt

The organic sulfate compound includes a sulfate of alkyl, alkenyl, alkynyl, aryl or heterocyclic monoether of polyethylene oxide. The number of ethylene oxide unit is preferably from 1 to 4. The salt is preferably a sodium salt, a potassium salt or a lithium salt Specific examples thereof include compounds described in Paragraph Nos. [0034] to [0038] of JP-A-2007-276454.

As the betaine compound, a compound wherein a number of carbon atoms included in a hydrocarbon substituent on the nitrogen atom is from 1 to 5 is preferred. Specific examples thereof include trimethylammonium acetate, dimethylpropylammonium acetate,
3-hydroxy-4-trimethylammoniobutyrate, 4-(1-pyridinio)butyrate,
1-hydroxyethyl-1-imidazolioacetate, trimethylammonium methanesulfonate, dimethylpropylammonium methanesulfonate, 3-trimethylammonio-1-porpanesulfonate and 3-(1-pyridinio)-1-porpanesulfonate.

Since the hydrophilic low molecular weight compound has a small structure of hydrophobic portion and almost no surface active function, degradations of the hydrophobicity and film strength in the image area due to penetration of dampening water into the exposed area (image area) of the image-recording layer are prevented and thus, the in a range and printing durability of the image-recording layer can be preferably maintained.

The content of the hydrophilic low molecular weight compound in the image-recording layer is preferably from 0.5 to 20% by weight, more preferably from 1 to 15% by weight, still more preferably from 2 to 10% by weight, based on the total solid content of the image-recording layer. In the range described above, good on-press development property and printing durability are obtained. The hydrophilic low molecular weight compounds may be used individually or as a mixture of two or more thereof.

### <Other components>

The image-recording layer preferably contains a chain transfer agent The chain transfer agent is defined, for example, in Kobunshi Jiten (Polymer Dictionary), Third Edition, pages 683 to 684, edited by The Society of Polymer Science, Japan (2005). As the chain transfer agent, for example, compounds having SH, PH, SiH or GeH in their molecules are used. The compound donates a hydrogen to a low active radical species to generate a radical or is oxidized and then deprotonized to generate a radical. In the image-recording layer according to the invention, a thiol compound (for example, a 2-mercaptobenzimidazole, a 2-mercaptobenzothiazole, a 2-mercaptobenzoxazole, a 3-mercaptotriazole or a 5-mercaptotetrazole) is preferably used.

The content of the chain transfer agent is preferably from 0.01 to 20 parts by weight, more preferably from 1 to 10 parts by weight, particularly preferably from 1 to 5 parts by weight, per 100 parts by weight of the total solid content of the image-recording layer.

Into the image-recording layer, various additives can be further incorporated, if desired. Examples of the additive include a surfactant for progressing the development property and improving the surface state of coated layer, a hydrophilic polymer for improving the development property and improving dispersion stability of microcapsule, a coloring agent or print-out agent for visually distinguishing the image area from the non-image area, a polymerization inhibitor for preventing undesirable thermal polymerization of the polymerizable compound during the production and preservation of the image-recording layer, a hydrophobic low molecular weight compound, for example, a higher fatty acid derivative for avoiding polymerization inhibition due to oxygen, an inorganic fine particle or organic fine particle for increasing strength of the cured layer in the image area, a co-sensitizer for increasing sensitivity and a plasticizer for improving plasticity. As the additives, known compounds, for example, compounds described in Paragraph Nos. [0161] to [0215] of JP-A-2007-206217, Paragraph No. [0067] of JP-T-2005-509192 and Paragraph Nos. [0023] to [0026] and [0059] to [0066] of JP-A-2004-310000 are used. With respect to the surfactant, surfactants which may be added to the developer described hereinafter may be used.

### <Formation of image-recording layer>

The image-recording layer according to the invention is formed by dispersing or dissolving each of the necessary components for image-recording layer described above in a solvent to prepare a coating solution and coating the solution. The solvent used include, for example, 2-butanone, ethylene glycol monomethyl ether, 1-methoxy-2-propanol, 2-methoxyethyl acetate, 1-methoxy-2-propyl acetate and γ-butyrolactone, but the invention should not be construed as being limited thereto. The solvents may be used individually or as a mixture. The solid content concentration of the coating solution is preferably from 1 to 50% by weight

The coating amount (solid content) of the image-recording layer is preferably from 0.3 to 3.0 g/m². Various methods can be used for the coating. Examples of the method include bar coater coating, spin coating, spray coating, curtain coating, dip coating, air knife coating, blade coating and roll coating.

### <Undercoat layer>

In the lithographic printing plate precursor according to the invention, an undercoat layer (also referred to as an intermediate layer) is preferably provided between the image-recording layer and the support. The undercoat layer strengthens adhesion between the support and the image-recording layer in the exposed area and makes removal of the image-recording layer from the support easy in the unexposed area, thereby contributing improvement in the development property without accompanying degradation of the printing durability. Further, it is advantageous that in the case of infrared laser exposure, since the undercoat layer acts as a heat insulating layer, decrease in sensitivity due to diffusion of heat generated upon the exposure into the support is prevented.

As a compound for use in the undercoat layer, a compound having an adsorbing group capable of adsorbing to a surface of support and a crosslinkable group for improving an adhesion property to the image-recording layer is preferred. Further, a compound having a hydrophilicity-imparting group, for example, a sulfo group is also exemplified as a preferable compound. The compound may be a low molecular weight compound or a polymer compound. The compounds may be used in mixture of two or more thereof, if desired.

As the polymer compound, a copolymer of a monomer having an adsorbing group, a monomer having a hydrophilic group and a monomer having a crosslinkable group is preferred. As the adsorbing group capable of adsorbing to a surface of support, a phenolic hydroxy group, a carboxyl group, -PO₃H₂, -OPO₃H₂, -CONHSO₂-, -SO₂NHSO₂- or -COCH₂COCH₃ is preferred. As the hydrophilic group, a sulfo group is preferred. As the crosslinkable group, for example, a methacryl group or an allyl group is preferred. The polymer compound may contain a crosslinkable group introduced by a salt formation between a polar substituent of the polymer compound and a compound containing a substituent having a counter charge to the polar substituent of the polymer compound and an ethylenically unsaturated bond and may also be further copolymerized with a monomer other than those described above, preferably a hydrophilic monomer.

Specifically, a silane coupling agent having an addition-polymerizable ethylenic double bond reactive group described in JP-A-10-282679 and a phosphorus compound having an ethylenic double bond reactive group described in JP-A-2-304441 are preferably exemplified. Low molecular weight compounds or polymer compounds having a crosslinkable group (preferably an ethylenically unsaturated bond group), a functional group capable of interacting with a surface of support and a hydrophilic group described in JP-A-2005-238816, JP-A-2005-125749, JP-A-2006-239867 and JP-A-2006-215263 are also preferably used.

Polymer compounds having an adsorbing group capable of adsorbing to a surface of support, a hydrophilic group and a crosslinkable group described in JP-A-2005-125749 and JP-A-2006-188038 are more preferred.

The content of the unsaturated double bond in the polymer compound for undercoat layer is preferably from 0.1 to 10.0 mmol, most preferably from 0.2 to 5.5 mmol, based on 1 g of the polymer compound.

The weight average molecular weight of the polymer compound for undercoat layer is preferably 5,000 or more, and more preferably from 10,000 to 1,000,000.

The undercoat layer according to the invention may contain a chelating agent, a secondary or tertiary amine, a polymerization inhibitor or a compound containing an amino group or a functional group having polymerization inhibition ability and a group capable of interacting with a surface of aluminum support (for example, 1,4-diazabicyclo[2,2,2]octane (DABCO), 2,3,5,6-tetrahydroxy-p-quinone, chloranil, sulfophthalic acid, hydroxyethylethylenediaminetriacetic acid, dihydroxyethylethylenediaminediacetic acid or hydroxyethyliminodiacetic acid) in addition to the compound for the undercoat layer described above in order to prevent the occurrence of stain due to the lapse of time.

The undercoat layer is coated according to a known method. The coating amount (solid content) of the undercoat layer is preferably from 0.1 to 100 mg/m², and more preferably from 1 to 30 mg/m².

### <Support>

As the support for use in the lithographic printing plate precursor according to the invention, a known support is used. Particularly, an aluminum plate subjected to roughening treatment and anodizing treatment according to a known method is preferred.

Also, an enlarging treatment or a sealing treatment of micropores of the anodized film described in JP-A-2001-253181 and JP-A-2001-322365 or a surface hydrophilizing treatment, for example, with an alkali metal silicate as described in U.S. Patents 2,714,066, 3,181,461, 3,280,734 and 3,902,734 or polyvinyl phosphonic acid as described in U.S. Patents 3,276,868, 4,153,461 and 4,689,272 may be appropriately selected and applied to the aluminum plate, if desired.

The support preferably has a center line average roughness from 0.10 to 1.2 µm.

The color density of the support is preferably from 0.15 to 0.65 in terms of the reflection density value. In the range described above, good image-forming property resulting from prevention of halation at the image exposure and good aptitude for plate inspection after development are achieved.

The thickness of the support is preferably from 0.1 to 0.6 mm, more preferably from 0.15 to 0.4 mm, and still more preferably from 0.2 to 0.3 mm.

The support according to the invention may have a backcoat layer containing an organic polymer compound described in JP-A-5-45885 or an alkoxy compound of silicon described in JP-A-6-35174, provided on the back surface thereof, if desired.

### [Protective layer]

In the lithographic printing plate precursor according to the invention, a protective layer (overcoat layer) may be provided on the image-recording layer. The protective layer has a function for preventing, for example, occurrence of scratch in the image-recording layer or ablation caused by exposure with a high illuminance laser beam, in addition to the function for restraining an inhibition reaction against the image formation by means of oxygen blocking.

With respect to the protective layer having such properties, there are described, for example, in U.S. Patent 3,458,311 and JP-B-55-49729. As a polymer having low oxygen permeability for use in the protective layer, any water-soluble polymer and water-insoluble polymer can be appropriately selected to use. The polymers may be used in mixture of two or more thereof, if desired. Specifically, for example, polyvinyl alcohol, a modified polyvinyl alcohol, polyvinyl pyrrolidone, a water-soluble cellulose derivative and poly(meth)acrylonitrile are exemplified.

As the modified polyvinyl alcohol, an acid-modified polyvinyl alcohol having a carboxyl group or a sulfo group is preferably used. Specifically, modified polyvinyl alcohols described in JP-A-2005-250216 and JP-A-2006-259137 are preferably exemplified.

It is also preferred for the protective layer to contain an inorganic stratiform compound, for example, natural mica or synthetic mica as described in JP-A-2005-119273 in order to increase the oxygen blocking property.

Further, the protective layer may contain a known additive, for example, a plasticizer for imparting flexibility, a surfactant for improving a coating property or a fine inorganic particle for controlling a surface slipping property. The oil-sensitizing agent described with respect to the image-recording layer may also be incorporated into the protective layer.

The protective layer is coated according to a known method. The coating amount of the protective layer is preferably in a range from 0.01 to 10 g/m², more preferably in a range from 0.02 to 3 g/m², most preferably in a range from 0.02 to 1 g/m², in terms of the coating amount after drying.

### [Plate making method]

Plate making of the lithographic printing plate precursor according to the invention is preferably performed by an on-press development method. The on-press development method includes a step in which the lithographic printing plate precursor is imagewise exposed and a printing step in which oily ink and an aqueous component are supplied to the exposed lithographic printing plate precursor without undergoing any development processing to perform printing, and it is characterized in that the unexposed area of the lithographic printing plate precursor is removed in the course of the printing step. The imagewise exposure may be performed on a printing machine after the lithographic printing plate precursor is mounted on the printing machine or may be separately performed using a platesetter or the like. In the latter case, the exposed lithographic printing plate precursor is mounted as it is on a printing machine without undergoing a development processing step. Then, the printing operation is initiated using the printing machine with supplying oily ink and an aqueous component and at an early stage of the printing the on-press development is carried out. Specifically, the image-recording layer in the unexposed area is removed and the hydrophilic surface of support is revealed therewith to form the non-image area. As the oily ink and aqueous component, printing ink an dampening water for conventional lithographic printing can be employed, respectively.

The plate making method is described in more detail below.

As the light source used for the image exposure in the invention, a laser is preferred. A wavelength of a laser light source for use in the invention is preferably from 300 to 450 nm or from 750 to 1,400 nm. In case of exposing with a light source of 300 to 450 nm, the lithographic printing plate precursor having an image-recording layer containing a sensitizing dye having an absorption maximum in such a wavelength range is preferably used. In case of exposing with a light source of 750 to 1,400 nm, the lithographic printing plate precursor having an image-recording layer containing an infrared absorbing agent, which is a sensitizing dye having an absorption maximum in such a wavelength range is preferably used. As the light source of 300 to 450 nm, a semiconductor laser is preferably used. As the light source of 750 to 1,400 nm, a solid laser or semiconductor laser emitting an infrared ray is preferably used. With respect to the infrared ray laser, the output is preferably 100 mW or more, the exposure time per pixel is preferably within 20 microseconds, and the irradiation energy is preferably from 10 to 300 mJ/cm². In order to reduce the exposure time, it is preferred to use a multibeam laser device. The exposure mechanism may be any of an internal drum system, an external drum system and a flat bed system.

Although the laser is not particularly restricted, for example, a solid laser or semiconductor laser emitting an infrared ray having a wavelength from 760 to 1,200 nm is preferably exemplified.

With respect to the infrared ray laser, the output is preferably 100 mW or more, the exposure time per pixel is preferably within 20 microseconds, and the irradiation energy is preferably from 10 to 300 mJ/cm². With respect to the laser exposure, in order to reduce the exposure time, it is preferred to use a multibeam laser device.

The exposed lithographic printing plate precursor is mounted on a plate cylinder of a printing machine. In case of using a printing machine equipped with a laser exposure apparatus, the lithographic printing plate precursor is mounted on a plate cylinder of the printing machine and then subjected to the imagewise exposure.

When dampening water and printing ink are supplied to the imagewise exposed lithographic printing plate precursor to perform printing, in the exposed area of the image-recording layer, the image-recording layer cured by the exposure forms the printing ink receptive area having the oleophilic surface. On the other hand, in the unexposed area, the uncured image-recording layer is removed by dissolution or dispersion with the dampening water and/or printing ink supplied to reveal the hydrophilic surface in the area. As a result, the dampening water adheres onto the revealed hydrophilic surface and the printing ink adheres onto the exposed area of the image-recording layer, whereby printing is initiated.

While either the dampening water or printing ink may be supplied at first on the surface of lithographic printing plate precursor, it is preferred to supply the printing ink at first in view of preventing the dampening water from contamination with the component of the image-recording layer removed.

Thus, the lithographic printing plate precursor according to the invention is subjected to the on-press development on an offset printing machine and used as it is for printing a large number of sheets.

### EXAMPLES

The present invention will be described in more detail with reference to the following examples, but the invention should not be construed as being limited thereto. With respect to the polymer compounds used in the examples, unless otherwise particularly defined, a molecular weight means a weight average molecular weight (Mw) and a ratio of repeating unit is indicated in mole percent.

### [Synthesis Example]

### (1) Synthesis of SB-2

In 200 ml of n-hexane were mixed 2.54 g of dipentaerythritol, 70.1 g of 3-mercaptopropionic acid and 1,90 g of p-toluenesulfonic acid monohydrate and the mixture was continued to reflux using a Dean-Stark trap until it was confirmed that about 11 ml of an aqueous phase was azeotroped into the trap. After cooling to room temperature, the reaction solution was diluted by adding 500 ml of ethyl acetate. The resulting organic solution was mixed with 300 ml of an aqueous saturated sodium hydrogen carbonate solution in a 1-liter beaker and the mixed solution was continued to stirr at room temperature until the bubbling was terminated. The mixed solution was put into a separation funnel and after removing the aqueous phase, the organic phase was washed with 200 ml of distilled water and then with 200 ml of saturated sodium chloride solution. The resulting organic phase was dried on anhydrous magnesium sulfate and concentrated under a reduced pressure to obtain 7.8 g of SB-2 as a colorless oily product It was confirmed by ¹H-NMR that the SB-2 obtained was a mixture of SB-2 and ethyl acetate (90 : 10 in weight ratio).

### (2) Synthesis of Binder P-1

In 500-ml tree-necked flask was weighed 69.18 g of 1-methoxy-2-propanol, followed by heating to 70°C under nitrogen flow. To the reaction vessel was added dropwise a mixed solution composed of 52.90 g of BLEMMER PME-100 (methoxydiethylene glycol monomethacrylate, produced by NOF Corp.), 35.17 g of methyl methacrylate, 6.05 g of methacrylic acid, 0.917 g of dipentaerythntol hexakis(3-mercaptopropionate), 0.809 g of V-601 (dimethyl 2,2'-azobis(isobutyrate), produced by Wako Pure Chemical Industries, Ltd.) and 70.10 g of 1-methoxy-2-propanol over a period of 2 hours and 30 minutes. After the completion of the dropwise addition, the reaction was further continued for 2 hours. After 2 hours, a mixed solution composed of 0.081 g of V-601 and 3.32 g of 1-methoxy-2-propanol was added and the temperature was raised to 90°C, followed by continuing to react for 2.5 hours. After the completion of the reaction, the reaction solution was cooled to room temperature.

To the reaction solution were added 97.73 g of 1-methoxy-2-propanol, 0.23 g of 4-hydroxytetramethylpiperidine-N-oxide, 6.49 g of glycidyl methacrylate and 0.90 g of betaine and the mixture was thoroughly stirred and then heated 92°C for 24 hours. After 24 hours, the reaction solution was cooled to room temperature and diluted by adding 78.84 g of 1-methoxy-2-propanol. Binder P-1 thus-obtained had the solid content concentration of 23% by weight and the weight average molecular weight measured by GPC and calculated in terms of polystyrene of 65,000.

### (3) Synthesis of Binders P-2, P-4 and P-5

Binders P-2, P-4 and P-5 were synthesized in the same manner as in Synthesis of Binder P-1 except for using glycidyl acrylate, vinyl glycidyl ether and allyl glycidyl ether in place of glycidyl methacrylate, respectively.

### (4) Synthesis of Binder P-3

In 500-ml tree-necked flask was weighed 69.18 g of 1-methoxy-2-propanol, followed by heating to 70°C under nitrogen flow. To the reaction vessel was added dropwise a mixed solution composed of 52.90 g of BLEMMER PME-100 (produced by NOF Corp.), 35.17 g of methyl methacrylate, 6.05 g of methacrylic acid, 0.917 g of dipentaerythritol hexakis(3-mercaptopropionate), 0.809 g of V-601 (produced by Wako Pure Chemical Industries, Ltd.) and 70.10 g of 1-methoxy-2-propanol over a period of 2 hours and 30 minutes. After the completion of the dropwise addition, the reaction was further continued for 2 hours. After 2 hours, a mixed solution composed of 0.081 g of V-601 and 3.32 g of 1-methoxy-2-propanol was added and the temperature was raised to 90°C, followed by continuing to react for 2.5 hours. After the completion of the reaction, the reaction solution was cooled to room temperature.

To the reaction solution were added 97.73 g of 1-methoxy-2-propanol, 0.23 g of 4-hydroxytetramethylpiperidine-N-oxide, 6.97 g of 4-chloromethylsturene and 35 ml of 1N aqueous sodium hydroxide solution and the mixture was thoroughly stirred and then heated 92°C for 24 hours. After 24 hours, the reaction solution was cooled to room temperature and diluted by adding 78.84 g of 1-methoxy-2-propanol. The solution thus-obtained was slowly added dropwise to 10 liters of ion-exchanged water with thoroughly stirring to deposit a binder. The binder deposited was collected by filtration, dried thoroughly under a reduced pressure and then dissolved again in 1-methoxy-2-propanol to obtain a solution of Binder P-3 in 1-methoxy-2-propanol. Binder P-3 thus-obtained had the solid content concentration of 23% by weight and the weight average molecular weight measured by GPC and calculated in terms of polystyrene of 62,000.

### (5) Synthesis of Binder P-6

Binder P-6 was synthesized in the same manner as in Synthesis of Binder P-3 except for changing 4-chloromethylstyrene to N-bromopropylmethacrylamide.

### <Examples 1 to 6 and Comparative Examples 1 to 3>

### [Preparation of Lithographic printing plate precursors (1) to (9)]

### (Preparation of Support (No. 1))

An aluminum plate according to JIS A1050 having a thickness of 0.3 mm was subjected to treatment by performing processes (a) to (k) shown below in this order.

### (a) Mechanical surface roughening treatment

Mechanical surface roughening of the aluminum plate was conducted by means of rotating roller-form nylon brushes while supplying a suspension (having specific gravity of 1.12) of an abrasive (silica sand) in water as an abrasion slurry liquid to the surface of the aluminum plate. The average particle size of the abrasive was 8 µm and the maximum particle size was 50 µm. The material of the nylon brush was 6·10 nylon, and the brush has a bristle length of 50 mm and a bristle diameter of 0.3 mm. The nylon brush was made by making holes in a stainless steel cylinder having a diameter of 300 mm and densely filling the brush bristles. Three of the rotating nylon brushes were used. Two supporting rollers (each having a diameter of 200 mm) provided under the brush rollers were spaced 300 mm. The brush rollers were pressed against the aluminum plate till the load applied to a driving motor for rotating the brush became 7 kW greater than the load before pressing the brush rollers against the aluminum plate. The rotating direction of the brushes was the same as the moving direction of the aluminum plate. The rotation number of the brush was 200 rpm.

### (b) Alkali etching treatment

Etching treatment of the aluminum plate was conducted by spraying an aqueous sodium hydroxide solution (sodium hydroxide concentration: 26% by weight, aluminum ion concentration: 6.5% by weight) having temperature of 70°C to dissolve the aluminum plate in an amount of 6 g/m², followed by washing by spraying well water.

### (c) Desmut treatment

Desmut treatment of the aluminum plate was conducted by spraying an aqueous 1% by weight nitric acid solution (containing 0.5% by weight of aluminum ion) having temperature of 30°C, followed by washing with water by spraying. The aqueous nitric acid solution used for the desmut treatment was a waste solution of the process of conducting electrochemical surface roughening treatment using alternating current in an aqueous nitric acid solution.

### (d) Electrochemical surface roughening treatment

Electrochemical surface roughening treatment of the aluminum plate was continuously conducted by applying 60 Hz alternating current voltage. The electrolytic solution used was an aqueous solution containing 10.5 g/liter of nitric acid (containing 5 g/liter of aluminum ion) and the solution temperature was 50°C. The electrochemical surface roughening treatment was conducted using an alternating current source, which provided a trapezoidal rectangular wave alternating current where time (TP) for reaching the current to its peak from zero was 0.8 msec and a duty ratio was 1:1, and using a carbon electrode as a counter electrode. A ferrite was used as an auxiliary anode. The electrolytic cell used was a radial cell type. The current density was 30 A/dm² at the peak current, and the electric amount was 220 C/dm² in terms of the total electric quantity during the aluminum plate functioning as an anode. To the auxiliary anode, 5% of the current from the electric source was divided. Subsequently, the plate was washed by spraying well water.

### (e) Alkali etching treatment

Etching treatment of the aluminum plate was conducted at 32°C by spraying an aqueous solution having a sodium hydroxide concentration of 26% by weight and an aluminum ion concentration of 6.5% by weight to dissolve the aluminum plate in an amount of 0.20 g/m². Thus, the smut component mainly comprising aluminum hydroxide formed in the precedent process of conducting electrochemical surface roughening treatment using alternating current was removed and an edge portion of the pit formed was dissolved to smoothen the edge portion. Subsequently, the plate was washed by spraying well water. The etching amount was 3.5 g/m².

### (f) Desmut treatment

Desmut treatment of the aluminum plate was conducted by spraying an aqueous 15% by weight nitric acid solution (containing 4.5% by weight of aluminum ion) having temperature of 30°C, followed by washing by spraying well water. The aqueous nitric acid solution used for the desmut treatment was a waste solution of the process of conducting electrochemical surface roughening treatment using alternating current in an aqueous nitric acid solution.

### (g) Electrochemical surface roughening treatment

Electrochemical surface roughening treatment of the aluminum plate was continuously conducted by applying 60 Hz alternating current voltage. The electrolytic solution used was an aqueous solution containing 7.5 g/liter of hydrochloric acid (containing 5 g/liter of aluminum ion) and the solution temperature was 35°C. The electrochemical surface roughening treatment was conducted using an alternating current source which provided a rectangular wave alternating current and using a carbon electrode as a counter electrode. A ferrite was used as an auxiliary anode. The electrolytic cell used was a radial cell type. The current density was 25 A/dm² at the peak current, and the electric amount was 50 C/dm² in terms of the total electric quantity during the aluminum plate functioning as an anode. Subsequently, the plate was washed by spraying well water.

### (h) Alkali etching treatment

Etching treatment of the aluminum plate was conducted at 32°C by spraying an aqueous solution having a sodium hydroxide concentration of 26% by weight and an aluminum ion concentration of 6.5% by weight to dissolve the aluminum plate in an amount of 0.10 g/m². Thus, the smut component mainly comprising aluminum hydroxide formed in the precedent process of conducting electrochemical surface roughening treatment using alternating current was removed and an edge portion of the pit formed was dissolved to smoothen the edge portion. Subsequently, the plate was washed by spraying well water.

### (i) Desmut treatment

Desmut treatment of the aluminum plate was conducted by spraying an aqueous 25% by weight sulfuric acid solution (containing 0.5% by weight of aluminum ion) having temperature of 60°C, followed by washing by spraying well water.

### (j) Anodizing treatment

As the electrolytic solution, sulfuric acid was used. The sulfuric acid concentration of the electrolytic solution was 170 g/liter (containing 0.5% by weight of aluminum ion) and the temperature was 43°C. The current density was about 30 A/dm². Subsequently, the plate was washed by spraying well water. The amount of the final anodic oxide film was 2.7 g/m².

### (k) Alkali metal silicate treatment

Alkali metal silicate treatment (silicate treatment) of aluminum plate As conducted by immersing the aluminum plate in an aqueous 1% by weight sodium silicate No. 3 solution having temperature of 30°C for 10 seconds. Subsequently, the plate was washed by spraying well water, whereby an aluminum support was prepared. The adhesion amount of the silicate was 3.6 mg/m².

### (Formation of undercoat layer)

A methanol solution of Polymer compound (1) (weight average molecular weight (Mw): 35,000) having the structure shown below was coated on the aluminum support by a wire bar and dried at 80°C for 60 seconds to form a undercoat layer. The coating amount was 0.01 g/m². Polymer compound (1):

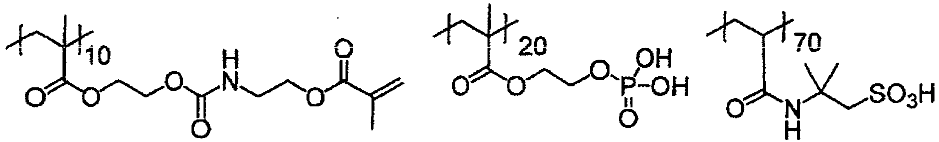

### (Formation of image-recording layer)

Subsequently, Coating solution (1) for image-recording layer having the composition shown below As coated using a bar and dried in an oven at 70°C for 60 seconds to from an image-recording layer having a dry coating amount of 1.0 g/m², thereby preparing a lithographic printing plate precursor.

### <Coating solution (1) for image-recording layer>

| | |
|---|---|
| Binder shown in Table 5 | 0.50 g |
| Polymerizable compound | 1.00 g |

Isocyanuric acid EO-modified triacrylate (NK ESTER
M-315, produced by Shin-Nakamura Chemical Co., Ltd.)

| | |
|---|---|
| Radical polymerization initiator (1) shown below | 0.20 g |
| Infrared absorbing agent (1) shown below | 0.05 g |
| Fluorine-based surfactant (1) shown below | 0.05 g |
| 1-Methoxy-2-propanol | 18.00 g |

### Radical polymerization initiator (1):

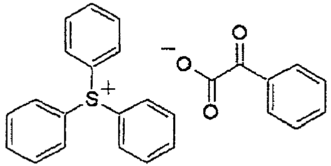

### Infrared absorbing agent (1):

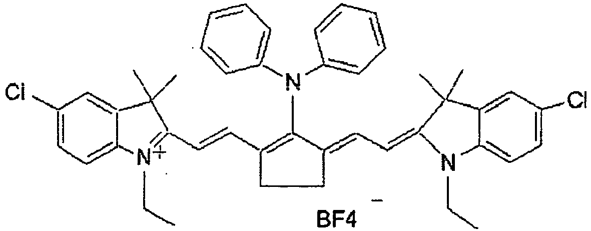

### Fluorine-based surfactant (1):

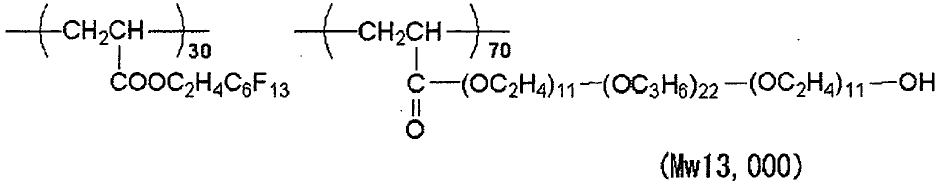

### [Exposure and Printing of Lithographic printing plate precursor]

Each of the lithographic printing plate precursors was subjected to imagewise exposure by TRENDSETTER 3244VX, produced by Creo Co., equipped with a water-cooled 40 W infrared semiconductor laser under the conditions of output of 9W, a rotational number of an external drum of 210 rpm and resolution of 2,400 dpi. The exposed lithographic printing plate precursor was mounted without undergoing development processing on a plate cylinder of a printing machine (SOR-M, produced by Heidelberg). Using dampening water (EU-3 (etching solution, produced by FUJIFILM Corp.)/water/isopropyl alcohol = 1/89/10 (by volume ratio)) and TRANS-G (N) black ink (produced by DIC Corp.), after supplying the dampening water and ink printing was performed on TOKUBISHI ART paper (76.5 kg) at a printing speed of 6,000 sheets per hour.

### [Evaluation]

### (1) Development property

A number of the printing papers required until the on-press development of the unexposed area of the image-recording layer on the printing machine was completed to reach a state where the ink was not transferred to the printing paper was measured to evaluate the on-press development property.

### (2) Printing durability

As increase in the number of printing sheets in the printing, the image-recording layer was gradually abraded to cause decrease in the ink receptivity, resulting in decrease of ink density on printing paper. A number of printed materials obtained until the ink density (reflection density) decreased by 0.1 from that at the initiation of printing was determined to evaluate the printing durability.

The evaluation results of (1) and (2) for each of the examples and comparative examples are shown in Table 5.

**TABLE 5: Examples 1 to 6 and Comparative Examples 1 to 3**

| | Lithographic Printing Plate Precursor | Binder | Printing Durability (sheets) | Development Property (sheets) |
|---|---|---|---|---|
| Example 1 | (1) | P-1 | 3 x 10⁴ | 8 |
| Example 2 | (2) | P-2 | 3 x 10⁴ | 8 |
| Example 3 | (3) | P-3 | 2.4 x 10⁴ | 8 |
| Example 4 | (4) | P-4 | 2.6 x 10⁴ | 8 |
| Example 5 | (5) | P-5 | 2 x 10⁴ | 8 |
| Example 6 | (6) | P-6 | 2.8 x 10⁴ | 8 |
| Comparative Example 1 | (7) | C-1 | 1 x 10⁴ | 10 |
| Comparative Example 2 | (8) | C-2 | 0.8 x 10⁴ | 12 |
| Comparative Example 3 | (9) | C-3 | 1 x 10⁴ | 500 |

| | | | | |
|---|---|---|---|---|
| Binders C-1 to C-3 used in the comparative examples are shown in Table 6 below. | | | | |

**TABLE 6: Binder for Comparative Example**

| Polymer No. | Central Nucleus | | Polymer Chain | | | | | | Mw (x 10⁴) |
|---|---|---|---|---|---|---|---|---|---|
| | No. | % by mole*1 | Polymerizable Group | % by mole*1 | Hydrophilic Group | %by mole | Other | % by mole | |
| C-1 | S-1 | 0.5 | | | 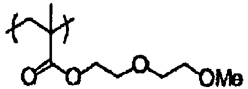 | 40 | 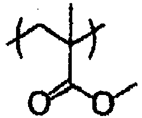 | 60 | 5.0 |
| C-2 | S-2 | 0.5 | | | 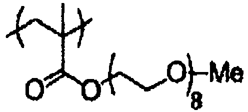 | 20 | 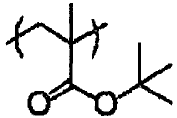 | 80 | 7.0 |
| C-3 | SB-2 | 1.01 | | | 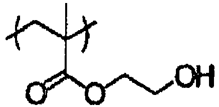 | 38 | 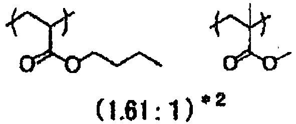 | 62 | 5.8 |
| C-4 | S-3 | 1.8 | 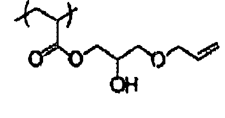 | 32 | 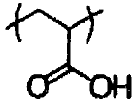 | 6 | 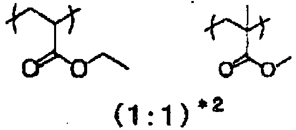 | 62 | 3.9 |

| | | | | | | | | | |
|---|---|---|---|---|---|---|---|---|---|
| * 1: A ratio of mole number (%) of SH group to the total mole number of the monomers. *2: A mole ratio of each unit is indicated in parentheses. | | | | | | | | | |

### Central nuclei of binders used in comparative examples

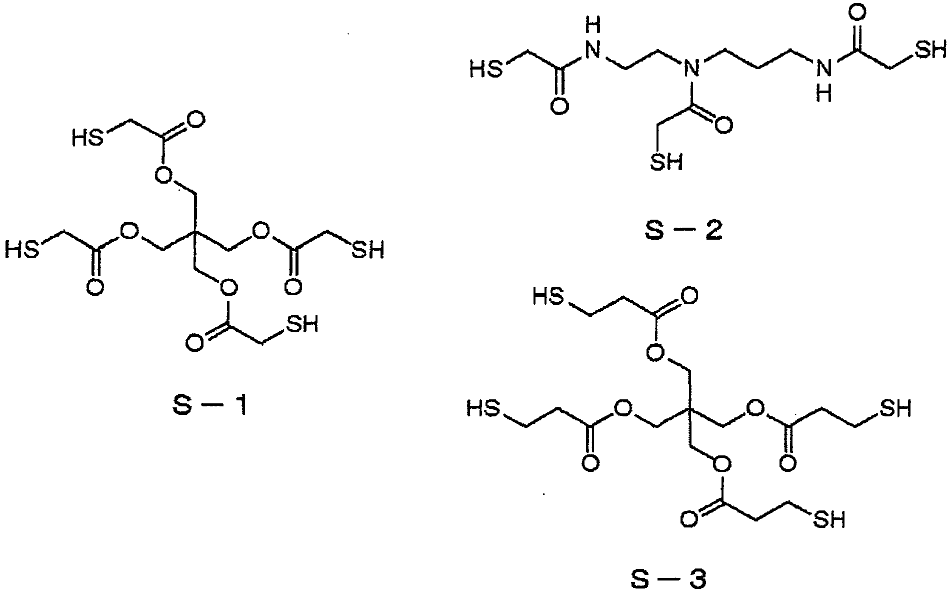

As is apparent from the results shown in Table 5, the binder according to the invention is excellent in the printing durability and development property in comparison with a conventional binder.

### <Examples 7 to 15>

### [Preparation of Lithographic printing plate precursors (10) to (18)]

### (Formation of undercoat layer)

A methanol solution of Polymer compound (1) (weight average molecular weight (Mw): 35,000) shown above was coated on the aluminum support described above by a wire bar and dried at 80°C for 60 seconds to form an undercoat layer. The coating amount was 0.02 g/m².

### (Formation of Image-recording layer)

Coating solution (2) for image-forming layer was coated on the support having the undercoat layer using a bar and dried in an oven at 100°C for 60 seconds to form an image-recording layer having a dry coating amount of 1.0 g/m². Coating solution (2) for image-recording layer was prepared by mixing Photosensitive solution (1) shown below with Microcapsule solution (2) shown below just before the coating, followed by stirring.

### <Photosensitive solution (1)>

| | |
|---|---|
| Binder shown in Table 7 | 0.162 g |
| Radical polymerization initiator (1) shown above | 0.160 g |
| Radical polymerization initiator (2) shown below | 0.180 g |
| Infrared absorbing agent (3) shown below | 0.020 g |
| Polymerizable compound | 0.385 g |

Isocyanuric acid EO-modified diacrylate (ARONIX
M-215, produced by Toagosei Co., Ltd.)

| | |
|---|---|
| Fluorine-based surfactant (1) shown above | 0.044 g |
| Phosphonium compound (1) shown below | 0.020 g |
| Methyl ethyl ketone | 1.091 g |
| 1-Methoxy-2-propanol | 8.210 g |

### Radical polymerization initiator (2):

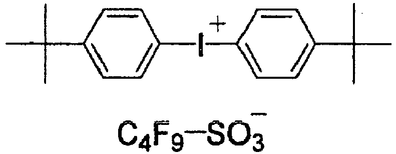

### Infrared absorbing agent (3):

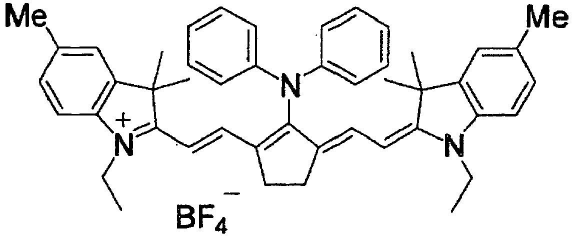

### Phosphonium compound (I):

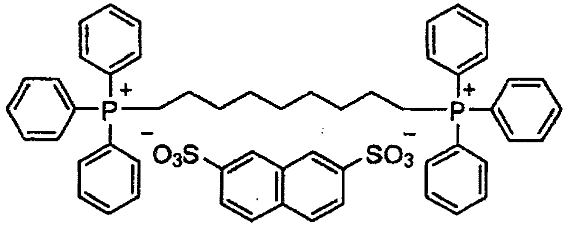

### <Microcapsule solution (2)>

| | |
|---|---|
| Microcapsule (2) prepared as shown below | 2.640 g |
| Water | 2.425 g |

### (Preparation of Microcapsule (2))

An oil phase component was prepared by dissolving 10 g of adduct of trimethylol propane and xylene diisocyanate (TAKENATE D-110N, produced by Mitsui Chemicals Inc., 75% by weight ethyl acetate solution), 6.00 g of SR-399 (dipentaerythritol pentaacrylate, produced by Sartomer Co., Inc.) and 0.12 g of PIONIN A-41C (calcium alkylbenzenesulfonate, produced by Takemoto Oil & Fat Co., Ltd.) in 16.67 g of ethyl acetate. As an aqueous phase component, 37.5 g of an aqueous 4% by weight solution of polyvinyl alcohol (PVA-205, produced by Kuraray Co., Ltd.) was prepared. The oil phase component and the aqueous phase component were mixed and the mixture was emulsified using a homogenizer at 12,000 rpm for 10 minutes. The resulting emulsion was added to 25 g of distilled water and stirred at room temperature for 30 minutes and then at 40°C for 2 hours. The microcapsule liquid thus-obtained was diluted using distilled water so as to have the solid content concentration of 15% by weight to prepare Microcapsule (2). The average particle size of the microcapsule was 0.2 µm.

Coating solution (1) for protective layer shown below was coated on the image-recording layer described above by a bar and dried in an oven at 125°C for 75 seconds to form a protective layer having a dry coating amount of 0.15 g/m², thereby preparing a lithographic printing plate precursor.

### <Coating solution (1) for protective layer>

| | |
|---|---|
| Polyvinyl alcohol (aqueous 6% by weight solution) (PVA-105, produced by Kuraray Co., Ltd, saponification degree: 98.5 % by mole, polymerization degree: 500) | 2.24 g |
| Polyvinyl pyrrolidone (K-30) | 0.0053 g |
| Surfactant (aqueous 1% by weight solution) (EMALEX 710, produced by Nihon Emulsion Co., Ltd.) | 2.15 g |
| Scale-like synthetic mica (aqueous 3.4% by weight dispersion) (MEB 3L, produced by UNICOO Co., Ltd., average particle size: 1 to 5 µm) | 3.75 g |
| Distilled water | 10.60 g |

### [Exposure and Printing of Lithographic printing plate precursor]

Each of the lithographic printing plate precursors was subjected to imagewise exposure by TRENDSETTER 3244VX, produced by Creo Co., equipped with a water-cooled 40 W infrared semiconductor laser under the conditions of output of 9W, a rotational number of an external drum of 210 rpm and resolution of 2,400 dpi. The exposed lithographic printing plate precursor was mounted without undergoing development processing on a plate cylinder of a printing machine (SOR-M, produced by Heidelberg). Using dampening water (EU-3 (etching solution, produced by FUJIFILM Corp.))/water/isopropyl alcohol = 1/89/10 (by volume ratio)) and TRANS-G (N) black ink (produced by DIC Corp.), after supplying the dampening water and ink printing was performed on TOKUBISHI ART paper (76.5 kg) at a printing speed of 6,000 sheets per hour.

### [Evaluation]

### (1) Development property

A number of the printing papers required until the on-press development of the unexposed area of the image-recording layer on the printing machine was completed to reach a state where the ink was not transferred to the printing paper was measured to evaluate the on-press development property.
63

### (2) Printing durability

As increase in the number of printing sheets in the printing, the image-recording layer was gradually abraded to cause decrease in the ink receptivity, resulting in decrease of ink density on printing paper. A number of printed materials obtained until the ink density (reflection density) decreased by 0.1 from that at the initiation of printing was determined to evaluate the printing durability.

The evaluation results of (1) and (2) for each of the examples and comparative examples are shown in Table 7.

**TABLE 7: Examples 7 to 15**

| | Lithographic Printing Plate Precursor | Binder | Printing Durability (sheets) | Development Property (sheets) |
|---|---|---|---|---|
| Example 7 | (10) | P-15 | 2.5 x 10⁴ | 10 |
| Example 8 | (11) | P-16 | 2.6 x 10⁴ | 10 |
| Example 9 | (12) | P-17 | 3.0 x 10⁴ | 10 |
| Example 10 | (13) | P-18 | 2.6 x 10⁴ | 10 |
| Example 11 | (14) | P-19 | 3.1 x 10⁴ | 6 |
| Example 12 | (15) | P-20 | 3.0 x 10⁴ | 7 |
| Example 13 | (16) | P-21 | 2.8 x 10⁴ | 8 |
| Example 14 | (17) | P-22 | 2.5 x 10⁴ | 10 |
| Example 15 | (18) | P-23 | 3.1 x 10⁴ | 6 |

As is apparent from the results shown in Table 7, the examples using the binder according to the invention exhibit good development property and printing durability.

### <Examples 16 to 56 and Comparative Examples 4 to 7>

### [Preparation of Lithographic printing plate precursors (19) to (63)]

### (Preparation of Support (No.2))

An aluminum plate (material: JIS A 1050) having a thickness of 0.3 mm was subjected to a degreasing treatment at 50°C for 30 seconds using an aqueous 10% by weight sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/cm³) of pumice having a median size of 25 µm, followed by thorough washing with water. The plate was subjected to etching by immersing in an aqueous 25% by weight sodium hydroxide solution of 45°C for 9 seconds, washed with water, then immersed in an aqueous 20% by weight nitric acid solution at 60°C for 20 seconds, and washed with water. The etching amount of the grained surface was about 3 g/m².

Then, using an alternating current of 60 Hz, an electrochemical roughening treatment was continuously carried out on the plate. The electrolytic solution used was an aqueous 1% by weight nitric acid solution (containing 0.5% by weight of aluminum ion) and the temperature of electrolytic solution was 50°C. The electrochemical roughening treatment was conducted using an alternating current source, which provides a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/dm² in terms of the peak value of the electric current, and 5% of the electric current flowing from the electric source was divided to the auxiliary anode. The quantity of electricity in the nitric acid electrolysis was 175 C/dm² in terms of the quantity of electricity when the aluminum plate functioned as an anode. The plate was then washed with water by spraying.

The plate was further subjected to an electrochemical roughening treatment in the same manner as in the nitric acid electrolysis above using as an electrolytic solution, an aqueous 0.5% by weight hydrochloric acid solution (containing 0.5% by weight of aluminum ion) having temperature of 50°C and under the condition that the quantity of electricity was 50 C/dm² in terms of the quantity of electricity when the aluminum plate functioned as an anode. The plate was then washed with water by spraying.

The plate was then subjected to an anodizing treatment using as an electrolytic solution, an aqueous 15% by weight sulfuric acid solution (containing 0.5% by weight of aluminum ion) at a current density of 15 A/dm² to form a direct current anodized film of 2.5 g/m², washed with water and dried to prepare Support (1).

Thereafter, in order to ensure the hydrophilicity of the non-image area, Support (1) was subjected to silicate treatment using an aqueous 2.5% by weight sodium silicate No. 3 solution at 60°C for 10 seconds. Subsequently, the plate was washed with water to obtain Support (2). The adhesion amount of Si was 10 mg/m². The center line average roughness (Ra) of the support was measured using a stylus having a diameter of 2 µm and found to be 0.51 µm.

### (Formation of Undercoat layer)

Coating solution (1) for undercoat layer shown below was coated on Support (2) so as to have a dry coating amount of 20 mg/m² to prepare a support having an undercoat layer.

### <Coating solution (1) for undercoat layer>

| | |
|---|---|
| Polymer compound (2) having structure shown below | 0.18 g |
| Hydroxyethyliminodiacetic acid | 0.10 g |
| Methanol | 55.24 g |
| Water | 6.15 g |

### Polymer compound (2):

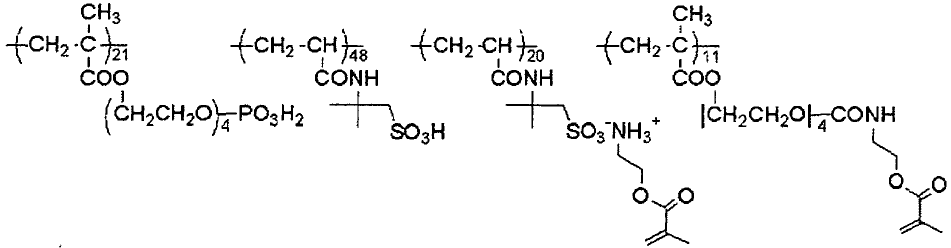

(Mw: 100,000)

### (Formation of Image-recording layer)

Coating solution (3) for image-recording layer having the composition shown below was coated on the undercoat layer formed as above by a bar and dried in an oven at 100°C for 60 seconds to form an image-recording layer having a dry coating amount of 1.0 g/m².

Coating solution (3) for image-recording layer was prepared by mixing Photosensitive solution (2) shown below with Microgel solution (2) shown below just before the coating, followed by stirring.

### <Photosensitive solution (2)>

| | |
|---|---|
| Binder shown in Table 8 | 0.240 g |
| Infrared absorbing dye (4) having structure shown below | 0.030 g |
| Radical polymerization initiator (3) having structure shown below | 0.162 g |
| Radical polymerizable compound (Tris(acryloyloxyethyl) isocyanurate (NK ESTER A-9300, produced by Shin-Nakamura Chemical Co., Ltd.)) | 0.192 g |
| Hydrophilic low molecular weight compound (Tris(2-hydroxyethyl) isocyanurate) | 0.062 g |
| Hydrophilic low molecular weight compound (1) having structure shown below | 0.050 g |
| Oil-sensitizing agent (Phosphonium compound (1) having structure shown below) | 0.055 g |
| Oil-sensitizing agent (Benzyl dimethyl octyl ammonium PF₆ salt) | 0.018 g |
| Oil-sensitizing agent (Ammonium group-containing polymer having structure shown below (reduced specific viscosity: 44 g/ml)) | 0.035 g |
| Fluorine-based surfactant (1) having structure shown above | 0.008 g |
| 2-Butanone | 1.091 g |
| 1-Methoxy-2-propanol | 8.609 g |

### <Microgel solution (2)>

| | |
|---|---|
| Microgel (1) shown below | 2.640 g |
| Distilled water | 2.425 g |

The structures of Infrared absorbing dye (4), Radical polymerization initiator (3), Phosphonium compound (1), Hydrophilic low molecular weight compound (1) and Oil-sensitizing agent (ammonium group-containing polymer) are shown below.

### Infrared absorbing dye (4):

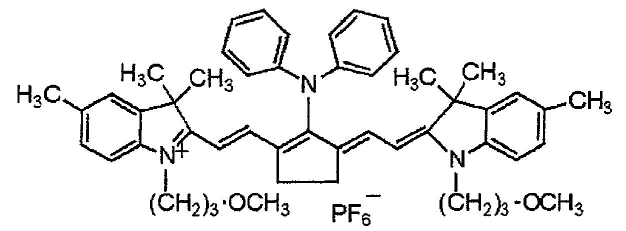

### Radical polymerization initiator (3):

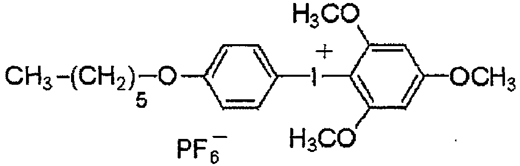

### Phosphonium compound (1):

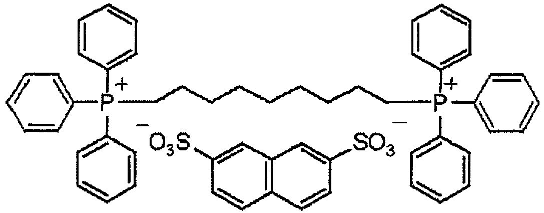

### Hydrophilic low molecular weight compound (1):

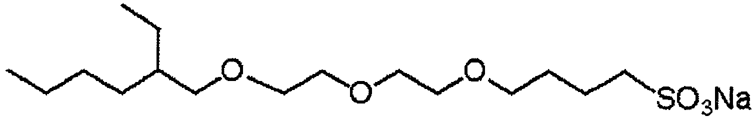

### Ammonium group-containing polymer:

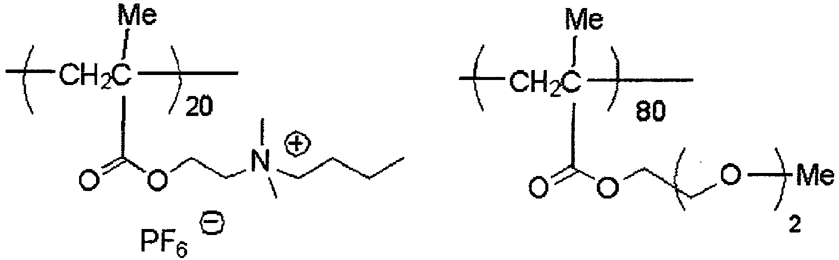

### <Preparation of Microgel (1)>

An oil phase component As prepared by dissolving 10 g of adduct of trimethylol propane and xylene diisocyanate (TAKENATE D-110N, produced by Mitsui Chemicals Polyurethanes, Inc.), 3.15 g of pentaerythritol triacrylate (SR444, produced by Nippon Kayaku Co., Ltd.) and 0.1 g of PIONIN A-41C (produced by Takemoto Oil & Fat Co., Ltd.) in 17 g of ethyl acetate. As an aqueous phase component, 40 g of an aqueous 4% by weight solution of polyvinyl alcohol (PVA-205, produced by Kuraray Co., Ltd) was prepared. The oil phase component and the aqueous phase component were mixed and the mixture was emulsified using a homogenizer at 12,000 rpm for 10 minutes. The resulting emulsion was added to 25 g of distilled water and stirred at room temperature for 30 minutes and then at 50°C for 3 hours. The microgel liquid thus-obtained was diluted using distilled water so as to have the solid concentration of 15% by weight to prepare Microgel (1). The average particle size of the microgel was measured by a light scattering method and found to be 0.2 µm.

### (Formation of Protective layer)

Coating solution (2) for protective layer having the composition shown below was coated on the image-recording layer described above by a bar and dried in an oven at 120°C for 60 seconds to form a protective layer having a dry coating amount of 0.15 g/m², thereby preparing Lithographic printing plate precursors (19) to (63), respectively.

### <Coating solution (2) for protective layer>

| | |
|---|---|
| Dispersion of inorganic stratiform compound (1) shown below | 1.5 g |
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 0.55 g |
| Aqueous 6% by weight solution of polyvinyl alcohol (PVA-405, saponification degree: 81.5 % by mole, polymerization degree: 500, produced by Kuraray Co., Ltd.) | 0.03 g |
| Aqueous 1% by weight solution of surfactant (EMALEX 710, produced by Nihon Emulsion Co., Ltd.) | 0.86 g |
| Ion-exchanged water | 6.0 g |

### <Preparation of Dispersion of inorganic stratiform compound (1)>

To 193.6 g of ion-exchanged water was added 6.4 g of synthetic mica (SOMASIF ME-100, produced by CO-OP Chemical Co., Ltd.) and the mixture was dispersed using a homogenizer until an average particle size (according to a laser scattering method) became 3 µm to prepare Dispersion of inorganic stratiform compound (1). The aspect ratio of the inorganic particle thus-dispersed was 100 or more.

### [Evaluation of Lithographic printing plate precursor]

### (1) On-press development property

Each of the lithographic printing plate precursors thus-obtained was exposed by LUXEL PLATESETTER T-6000III equipped with an infrared semiconductor laser, produced by FUJIFILM Corp. under the conditions of a rotational number of an external drum of 1,000 rpm, laser output of 70% and resolution of 2,400 dpi. The exposed image contained a solid image and a 50% halftone dot chart of a 20 µm-dot FM screen.

The exposed lithographic printing plate precursor was mounted without undergoing development processing on a plate cylinder of a printing machine (LITHRONE 26, produced by Komori Corp.). Using dampening water (ECOLITY-2 (produced by Fuji Film Co., Ltd.)/tap water = 2/98 (volume ratio)) and NEW CERVO (X) black ink (produced by Tokyo Printing Ink Mfg. Co., Ltd.), the dampening water and ink were supplied according to the standard automatic printing start method of LITHRONE 26 to conduct printing on 100 sheets of TOKUBISHI art paper (76.5 kg) at a printing speed of 10,000 sheets per hour.

A number of the printing papers required until the on-press development of the unexposed area of the image-recording layer on the printing machine was completed to reach a state where the ink was not transferred to the printing paper in the non-image area was measured to evaluate the on-press development property. The results obtained are shown in Table 8.

### (2) Printing durability

After performing the evaluation for the on-press development property described above, the printing was continued. As the increase in a number of printing papers, the image-recording layer was gradually abraded to cause decrease in the ink density on the printed material. A number of printed materials wherein a value obtained by measuring a halftone dot area rate of the 50% halftone dot of FM screen on the printed material using a Gretag densitometer decreased by 5% from the value measured on the 100^{th} paper of the printing was determined to evaluate the printing durability. The results obtained are shown in Table 8.

**TABLE 8: Examples 16 to 56 and Comparative Examples 4 to 7**

| | Lithographic Printing Plate Precursor | Binder | Printing Durability (sheets) | Development Property (sheets) |
|---|---|---|---|---|
| Example 16 | (19) | P-23 | 5.0 x 10⁴ | 9 |
| Example 17 | (20) | P-24 | 4.2 x 10⁴ | 13 |
| Example 18 | (21) | P-25 | 4.8 x 10⁴ | 11 |
| Example 19 | (22) | P-26 | 4.9 x 10⁴ | 10 |
| Example 20 | (23) | P-27 | 4.9 x 10⁴ | 10 |
| Example 21 | (24) | P-28 | 4.1 x 10⁴ | 13 |
| Example 22 | (25) | P-29 | 4.1 x 10⁴ | 13 |
| Example 23 | (26) | P-30 | 4.9 x 10⁴ | 10 |
| Example 24 | (27) | P-31 | 4.8 x 10⁴ | 11 |
| Example 25 | (28) | P-32 | 4.9 x 10⁴ | 10 |
| Example 26 | (29) | P-33 | 4.8 x 10⁴ | 10 |
| Example 27 | (30) | P-34 | 4.1 x 10⁴ | 13 |
| Example 28 | (31) | P-35 | 4.8 x 10⁴ | 11 |
| Example 29 | (32) | P-36 | 4.6 x 10⁴ | 11 |
| Example 30 | (33) | P-37 | 4.8 x 10⁴ | 11 |
| Example 31 | (34) | P-38 | 4.8 x 10⁴ | 11 |
| Example 32 | (35) | P-39 | 4.1 x 10⁴ | 13 |
| Example 33 | (36) | P-40 | 4.1 x 10⁴ | 13 |
| Example 34 | (37) | P-41 | 4.1 x 10⁴ | 13 |
| Example 35 | (38) | P-42 | 4.1 x 10⁴ | 13 |
| Example 36 | (39) | P-43 | 3.8 x 10⁴ | 15 |
| Example 37 | (40) | P-44 | 3.8 x 10⁴ | 15 |
| Example 38 | (41) | P-45 | 4.8 x 10⁴ | 11 |
| Example 39 | (42) | P-46 | 4.8 x 10⁴ | 11 |
| Example 40 | (43) | P-47 | 4.8 x 10⁴ | 11 |
| Example 41 | (44) | P-48 | 4.8 x 10⁴ | 11 |
| Example 42 | (45) | P-49 | 4.6 x 10⁴ | 12 |
| Example 43 | (46) | P-50 | 4.8 x 10⁴ | 11 |
| Example 44 | (47) | P-51 | 4.8 x 10⁴ | 11 |
| Example 45 | (48) | P-52 | 4.1 x 10⁴ | 13 |
| Example 46 | (49) | P-53 | 4.1 x 10⁴ | 13 |
| Example 47 | (50) | P-54 | 4.1 x 10⁴ | 13 |
| Example 48 | (51) | P-55 | 4.1 x 10⁴ | 13 |
| Example 49 | (52) | P-56 | 4.1 x 10⁴ | 13 |
| Example 50 | (53) | P-57 | 4.1 x 10⁴ | 13 |
| Example 51 | (54) | P-58 | 4.1 x 10⁴ | 13 |
| Example 52 | (55) | P-59 | 4.1 x 10⁴ | 13 |
| Example 53 | (56) | P-60 | 4.1 x 10⁴ | 13 |
| Example 54 | (57) | P-61 | 4.8 x 10⁴ | 11 |
| Example 55 | (58) | P-62 | 4.8 x 10⁴ | 11 |
| Example 56 | (59) | P-63 | 4.1 x 10⁴ | 13 |
| Comparative Example 4 | (60) | C-1 | 3.0 x 10⁴ | 20 |
| Comparative Example 5 | (61) | C-2 | 2.8 x 10⁴ | 23 |
| Comparative Example 6 | (62) | C-3 | 3.0 x 10⁴ | 500 |
| Comparative Example 7 | (63) | C-4 | 3.1 x 10⁴ | 500 |

As is apparent from the results shown in Table 8, the development property and printing durability are improved by using the binder according to the invention.

### Examples 57 to 62

### [Preparation of Lithographic printing plate precursors (64) to (69)]

### (Formation of Undercoat layer)

Coating solution (1) for undercoat layer shown above was coated on Support (2) prepared in Preparation of Support (No. 2) described above so as to have a dry coating amount of 20 mg/m² to prepare a support having an undercoat layer for using in the experiments described below.

### (Formation of Image-recording layer)

Coating solution (4) for image-recording layer having the composition shown below was coated on the undercoat layer formed as above by a bar and dried in an oven at 100°C for 60 seconds to form an image-recording layer having a dry coating amount of 1.0 g/m².

Coating solution (4) for image-recording layer was prepared by mixing Photosensitive solution (3) shown below with Microgel solution (2) shown above just before the coating, followed by stirring.

### <Photosensitive solution (3)>

| | |
|---|---|
| Binder P-1 | 0.250 g |
| Infrared absorbing dye (4) having structure shown above | 0.030 g |
| Radical polymerization initiator shown in Table 9 | 0.162 g |
| Radical polymerizable compound (Tris(acryloyloxyethyl) isocyanurate (NK ESTER A-9300, produced by Shin-Nakamura Chemical Co., Ltd.)) | 0.192 g |
| Hydrophilic low molecular weight compound (Tris(2-hydroxyethyl) isocyanurate) | 0.062 g |
| Hydrophilic low molecular weight compound (1) having structure shown above | 0.050 g |
| Oil-sensitizing agent (Phosphonium compound (1) having structure shown above) | 0.055 g |
| Oil-sensitizing agent (Benzyl dimethyl octyl ammonium PF₆ salt) | 0.018 g |
| Oil-sensitizing agent (Ammonium group-containing polymer having structure shown above (reduced specific viscosity: 44 g/ml)) | 0.035 g |
| Fluorine-based surfactant (1) having structure shown above | 0.008 g |
| 2-Butanone | 1.091 g |
| 1-Methoxy-2-propanol | 8.609 g |

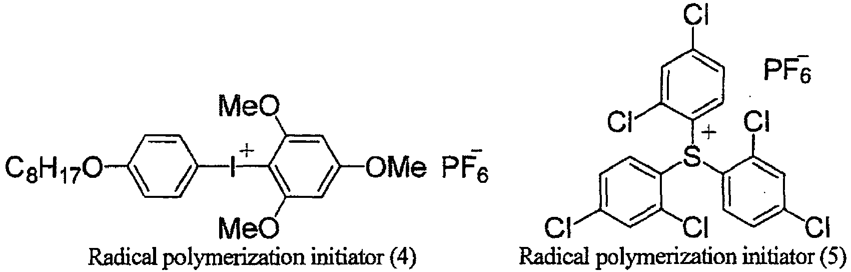

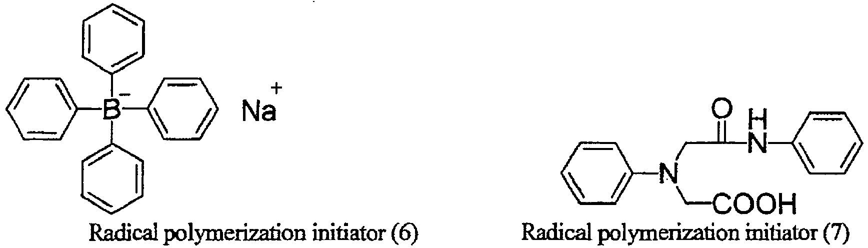

### (Formation of Protective layer)

Coating solution (2) for protective layer having the composition shown above was coated on the image-recording layer described above by a bar and dried in an oven at 120°C for 60 seconds to form a protective layer having a dry coating amount of 0.15 g/m², thereby preparing Lithographic printing plate precursors (64) to (69), respectively.

### [Evaluation of Lithographic printing plate precursor]

### (1) On-press development property

Each of the lithographic printing plate precursors thus-obtained was exposed by LUXEL PLATESETTER T-6000III equipped with an infrared semiconductor laser, produced by FUJIFILM Corp. under the conditions of a rotational number of an external drum of 1,000 rpm, laser output of 70% and resolution of 2,400 dpi. The exposed image contained a solid image and a 50% halftone dot chart of a 20 µm-dot FM screen.

The exposed lithographic printing plate precursor was mounted without undergoing development processing on a plate cylinder of a printing machine (LITHRONE 26, produced by Komori Corp.). Using dampening water (ECOLITY-2 (produced by Fuji Film Co., Ltd.)/tap water = 2/98 (volume ratio)) and NEW CERVO (X) black ink (produced by Tokyo Printing Ink Mfg. Co., Ltd.), the dampening water and ink were supplied according to the standard automatic printing start method of LITHRONE 26 to perform on-press development and to conduct printing on 100 sheets of TOKUBISHI art paper (76.5 kg) at a printing speed of 10,000 sheets per hour.

A number of the printing papers required until the on-press development of the unexposed area of the image-recording layer on the printing machine was completed to reach a state where the ink was not transferred to the printing paper in the non-image area was measured to evaluate the on-press development property. The results obtained are shown in Table 9.

### (2) Printing durability

After performing the evaluation for the on-press development property described above, the printing was continued. As the increase in a number of printing papers, the image-recording layer was gradually abraded to cause decrease in the ink density on the printed material. A number of printed materials wherein a value obtained by measuring a halftone dot area rate of the 50% halftone dot of FM screen on the printed material using a Gretag densitometer decreased by 5% from the value measured on the 100^{th} paper of the printing was determined to evaluate the printing durability. The results obtained are shown in Table 9.

**TABLE 9: Examples 57 to 62**

| | Lithographic Printing Plate Precursor | Initiator System | | | Printing Durability (sheets) | Development Property (sheets) |
|---|---|---|---|---|---|---|
| | | Radical Polymerization Initiator A | Radical Polymerization Initiator B | A/B in Ratio by Weight | | |
| Example 57 | (64) | (4) | None | - | 5.5 x 10⁴ | 10 |
| Example 58 | (65) | (4) | (6) | 89/11 | 8.0 x 10⁴ | 10 |
| Example 59 | (66) | (4) | (7) | 80/20 | 7.0 x 10⁴ | 13 |
| Example 60 | (67) | (5) | None | - | 6.0 x 10⁴ | 12 |
| Example 61 | (68) | (5) | (6) | 89/11 | 9.0 x 10⁴ | 14 |
| Example 62 | (69) | (5) | (7) | 80/20 | 7.5 x 10⁴ | 15 |

## Claims

1. A lithographic printing plate precursor comprising: a support; and an image-recording layer containing a binder, a radical polymerizable compound and a radical polymerization initiator, wherein the binder comprises a polymer compound having a nucleus being derived from a multifunctional thiol having from 6 to 10 thiol groups and polymer chains connected to the nucleus through sulfide bonds derived from these thiol groups and the polymer chains have a polymerizable group.

2. The lithographic printing plate precursor as claimed in Claim 1, wherein the polymerizable group is an acryl group or a methacryl group.

3. The lithographic printing plate precursor as claimed in Claim 1 or 2, wherein the polymer chain has a substituent represented by the following formula (1):
-(CH₂CH₂O)ₙR (1)
wherein n represents an integer from 1 to 100 and R represents a hydrogen atom or an alkyl group having from 1 to 18 carbon atoms.

4. The lithographic printing plate precursor as claimed in Claim 3, wherein n represents an integer from 1 to 4 and R represents a hydrogen atom or a methyl group.

5. The lithographic printing plate precursor as claimed in any one of Claims 1 to 4, wherein the polymer chain is a polymer chain obtained by radical polymerization of at least one of a (meth)acrylic acid monomer, a styrene monomer and a vinyl monomer.

6. The lithographic printing plate precursor as claimed in any one of Claims 1 to 5, wherein the image-recording layer contains as the radical polymerization initiator, an onium salt compound and one of an organic borate salt compound and a carboxylic acid-based compound.

7. The lithographic printing plate precursor as claimed in Claim 6, wherein the onium salt compound is an iodonium salt, a sulfonium salt or an azinium salt.

8. The lithographic printing plate precursor as claimed in any one of Claims 1 to 7, wherein the image-recording layer further contains an infrared absorbing agent.

9. The lithographic printing plate precursor as claimed in any one of Claims 1 to 8, which further comprises a protective layer so that the support, the image-recording layer and the protective layer are provided in this order.

10. The lithographic printing plate precursor as claimed in any one of Claims 1 to 9, wherein an undercoat layer is provided between the support and the image-recording layer.

11. The lithographic printing plate precursor as claimed in any one of Claims 1 to 10, which is capable of printing after image exposure with laser, by mounting the lithographic printing plate precursor on a printing machine and supplying printing ink and dampening water to remove an unexposed area of the image-recording layer.

12. The lithographic printing plate precursor as claimed in any one of Claims 1 to 11, wherein the polymer compound is selected from one or more kinds of polymers P-1 to P-14 listed in the following table, wherein the central nucleus SB-2 has a ratio of mole number in % of SH group to the total mole number of the monomers of 1 %, wherein SB-2 represents dipentaerythritol hexakis(3-mercaptopropionate) and wherein Mw represents a weight average molecular weight measured by GPC calculated in terms of polystyrene.
| Polymer No. | Central Nucleus | Polymerizable Group (% by Mole) | Hydrophilic Group (% by Mole) | Other (% by Mole) | Mw (x10⁴) |
|---|---|---|---|---|---|
| P-1 | SB-2 | 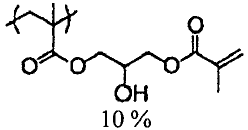 | 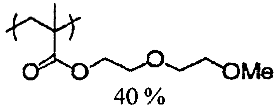 | 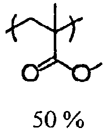 | 6.5 |
| P-2 | SB-2 | 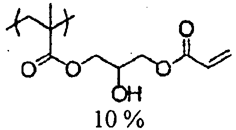 | 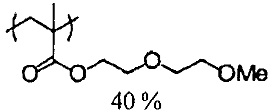 | 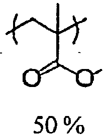 | 6.4 |
| P-3 | SB-2 | 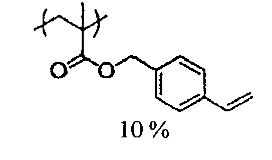 | 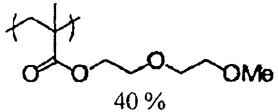 | 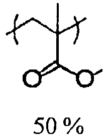 | 6.2 |
| P-4 | SB-2 | 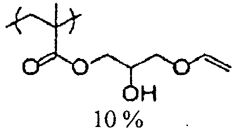 | 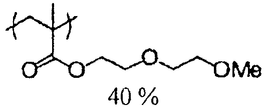 | 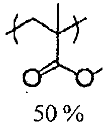 | 6.6 |
| P-5 | SB-2 | 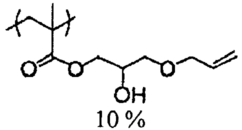 | 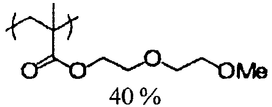 | 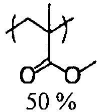 | 6.7 |
| P-6 | SB-2 | 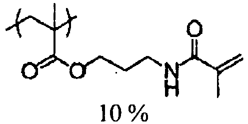 | 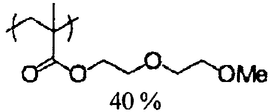 | 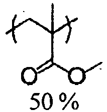 | 6.9 |
| P-7 | SB-2 | 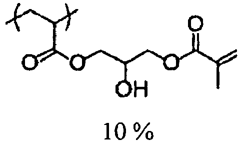 | 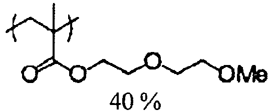 | 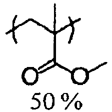 | 6.1 |
| P-8 | SB-2 | 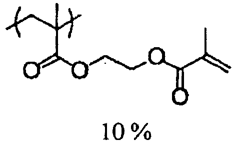 | 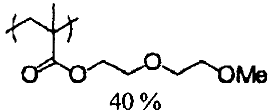 | 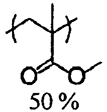 | 7.1 |
| P-9 | SB-2 | 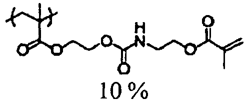 | 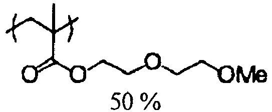 | 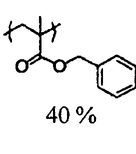 | 6.6 |
| P-10 | SB-2 | 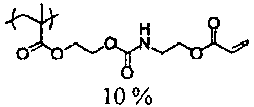 | 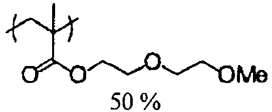 | 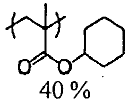 | 6.2 |
| P-11 | SB-2 | 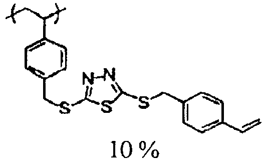 | 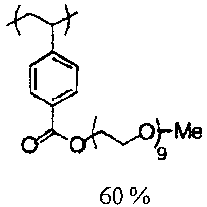 | 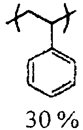 | 5.8 |
| P-12 | SB-2 | 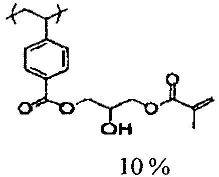 | 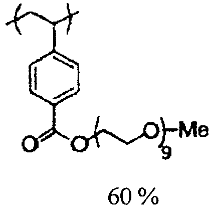 | 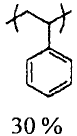 | 5.7 |
| P-13 | SB-2 | 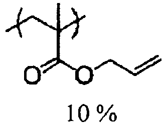 | 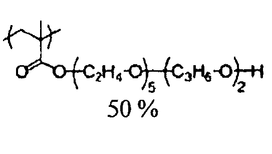 | 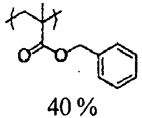 | 7.8 |
| P-14 | SB-2 | 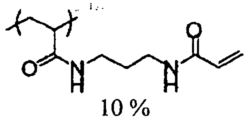 | 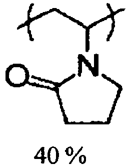 | 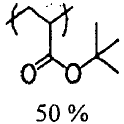 | 7.0 |

13. A lithographic printing method comprising, after image exposure of the lithographic printing plate precursor as claimed in Claim 11 with laser, mounting the exposed lithographic printing plate precursor on a printing machine and supplying printing ink and dampening water to remove an unexposed area of the image-recording layer, to conduct printing.

## Patentansprüche

1. Lithographiedruckplattenvorläufer, umfassend: einen Träger; und eine Bildaufzeichnungsschicht, die ein Bindemittel, eine radikalisch polymerisierbare Verbindung und einen Initiator der radikalischen Polymerisation enthält, worin das Bindemittel eine Polymerverbindung umfasst, die einen Kern, der aus einem multifunktionellen Thiol mit 6 bis 10 Thiolgruppen abgeleitet ist, und Polymerketten aufweist, die an den Kern durch Sulfidbindungen gebunden sind, die aus diesen Thiolgruppen erhalten sind, und die Polymerketten eine polymerisierbare Gruppe aufweisen.

2. Lithographiedruckplattenvorläufer gemäß Anspruch 1, worin die polymerisierbare Gruppe eine Acrylgruppe oder eine Methacrylgruppe ist.

3. Lithographiedruckplattenvorläufer gemäß Anspruch 1 oder 2, worin die Polymerkette einen durch die folgende Formel (1) dargestellten Substituenten aufweist:
-(CH₂CH_{2O})ₙR (1)
worin n eine ganze Zahl von 1 bis 100 darstellt und R ein Wasserstoffatom oder eine Alkylgrupp mit 1 bis 18 Kohlenstoffatomen darstellt.

4. Lithographiedruckplattenvorläufer gemäß Anspruch 3, worin n eine ganze Zahl von 1 bis 4 darstellt und R ein Wasserstoffatom oder eine Methylgruppe darstellt.

5. Lithographiedruckplattenvorläufer gemäß irgendeinem der Ansprüche 1 bis 4, worin die Polymerkette eine Polymerkette ist, die durch radikalische Polymerisation von zumindest einem von einem (Meth)acrylsäure-Monomer, einem Styrol-Monomer und einem Vinyl-Monomer erhalten ist.

6. Lithographiedruckplattenvorläufer gemäß irgendeinem der Ansprüche 1 bis 5, worin die Bildaufzeichnungsschicht als Initiator der radikalischen Polymerisation eine Oniumsalzverbindung und eines von einer organischen Boratsalzverbindung und einer Carbonsäure-basierten Verbindung umfasst.

7. Lithographiedruckplattenvorläufer gemäß Anspruch 6, worin die Oniumsalzverbindung ein Jodoniumsalz, ein Sulfoniumsalz oder ein Aziniumsalz ist.

8. Lithographiedruckplattenvorläufer gemäß irgendeinem der Ansprüche 1 bis 7, worin die Bildaufzeichnungsschicht ferner einen Infrarotabsorber umfasst.

9. Lithographiedruckplattenvorläufer gemäß irgendeinem der Ansprüche 1 bis 8, der ferner eine Schutzschicht umfasst, so dass der Träger, die Bildaufzeichnungsschicht und die Schutzschicht in dieser Reihenfolge vorgesehen sind.

10. Lithographiedruckplattenvorläufer gemäß irgendeinem der Ansprüche 1 bis 9, worin eine Unterzugsschicht zwischen dem Träger und der Bildaufzeichnungsschicht vorgesehen ist.

11. Lithographiedruckplattenvorläufer gemäß irgendeinem der Ansprüche 1 bis 10, der zum Drucken nach der Bildbelichtung mit einem Laser befähigt ist, indem der Lithographiedruckplattenvorläufer auf einer Druckmaschine montiert wird und Drucktinte und Anfeuchtwasser zugeführt werden, um einen nicht-belichteten Bereich der Bildaufzeichnungsschicht zu entfernen.

12. Lithographiedruckplattenvorläufer gemäß irgendeinem der Ansprüche 1 bis 11, worin die Polymerverbindung ausgewählt ist aus einer oder mehr Arten der Polymere P-1 bis P-14, die in der folgenden Tabelle angegeben sind, worin der Zentralkern SB-2 ein Verhältnis der Molzahl in % an SH-Gruppen zur Gesamt-Molzahl der Monomere von 1 % aufweist, worin SB-2 Dipentaerythritolhexakis(3-mercaptopropionat) darstellt, und worin Mw das gewichtsgemittelte Molekulargewicht darstellt, gemessen mittels GPC und berechnet auf Grundlage von Polystyrol.
| Polymer-verbindung Nr. | Zentral-kern | Polymeristerbare Gruppe (mol%) | Hydrophile Gruppe (mol%) | Weitere (mol%) | Mw (x10⁴) |
|---|---|---|---|---|---|
| P-1 | SB-2 | 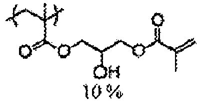 | 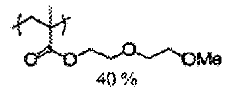 | 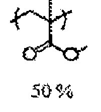 | 6,5 |
| P-2 | SB-2 | 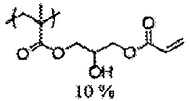 | 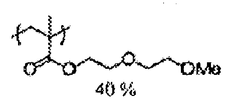 | 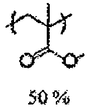 | 6,4 |
| P-3 | SB**-**2 | 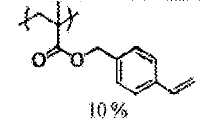 | 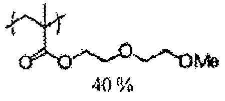 | 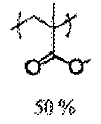 | 6,2 |
| P-4 | SB-2 | 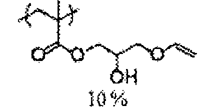 | 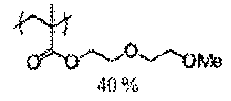 | 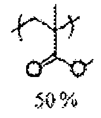 | 6,6 |
| P-5 | SB-2 | 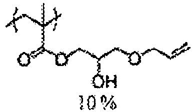 | 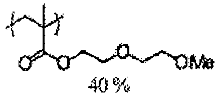 | 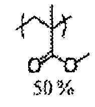 | 6,7 |
| P-6 | SB-2 | 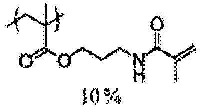 | 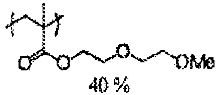 | 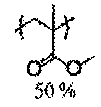 | 6,9 |
| P-7 | SB-2 | 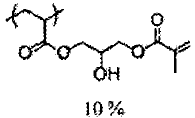 | 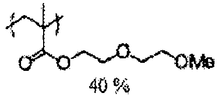 | 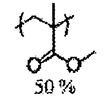 | 6,1 |
| P-8 | SB-2 | 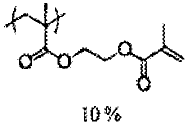 | 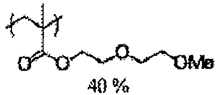 | 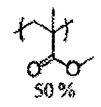 | 7,1 |
| P-9 | SB-2 | 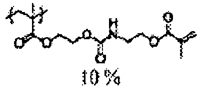 | 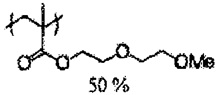 | 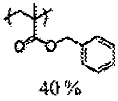 | 6,5 |
| P-10 | SB-2 | 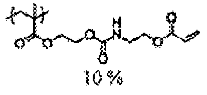 | 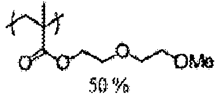 | 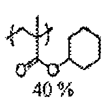 | 6,2 |
| P-11 | SB-2 | 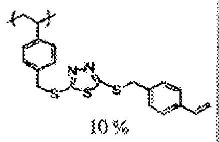 | 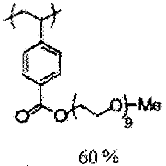 | 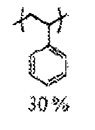 | 5,8 |
| P-12 | SB-2 | 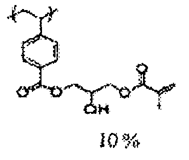 | 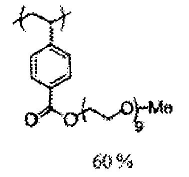 | 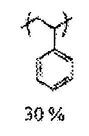 | 5,7 |
| P-13 | SB-2 | 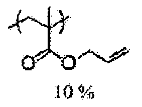 | 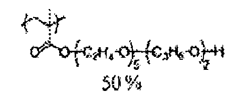 | 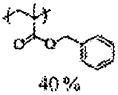 | 7,8 |
| P-14 | SB-2 | 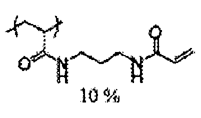 | 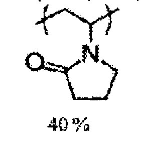 | 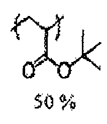 | 7,0 |

13. Lithographie-Druckverfahren, umfassend, nach der Bildbelichtung des Lithographiedruckplattenvorläufers gemäß Anspruch 11 mit einem Laser, das Montieren des belichteten Lithographiedruckplattenvorläufers auf einer Druckmaschine und das Zuführen von Drucktinte und Anfeuchtwasser, um einen nicht-belichteten Bereich der Bildaufzeichnungsschicht zu entfernen, um das Drucken durchzuführen.

## Revendications

1. Précurseur de plaque d'impression lithographique comprenant : un support ; une couche d'enregistrement d'une image contenant un liant, un composé polymérisable par des radicaux et un initiateur de polymérisation radicalaire, dans lequel le liant comprend un composé polymère ayant un noyau étant dérivé d'un thiol multifonctionnel ayant de 6 à 10 groupes thiols et des chaînes polymères connectées au noyau via des liaisons sulfures de ces groupes thiols et les chaînes polymères présentent un groupe polymérisable.

2. Précurseur de plaque d'impression lithographique selon la revendication 1, dans lequel le groupe polymérisable consiste en un groupe acryl ou un groupe méthacryl.

3. Précurseur de plaque d'impression lithographique selon la revendication 1 ou 2, dans lequel la chaîne polymère présente un substituant représenté par la formule (1) :
-(CH₂CH₂O)ₙR (1)
dans lequel n représente un nombre entier compris entre 1 et 100 et R représente un atome d'hydrogène ou un groupe alkyl ayant de 1 à 18 atomes de carbone.

4. Précurseur de plaque d'impression lithographique selon la revendication 3, dans lequel n représente un nombre entier compris entre 1 et 4 et R représente un atome d'hydrogène ou un groupe méthyle.

5. Précurseur de plaque d'impression lithographique selon l'une des revendications 1 à 4, dans lequel la chaîne polymère est une chaîne polymère obtenue par polymérisation radicalaire d'au moins un monomère parmi un monomère d'acide (méth)acrylique, un monomère styrène et un monomère vinyle.

6. Précurseur de plaque d'impression lithographique selon l'une des revendications 1 à 5, dans lequel la couche d'enregistrement d'une image contient un initiateur de polymérisation radicalaire, un composé de sel d'onium et un composé parmi un composé de sel de borate organique et un composé à base d'acide carboxylique.

7. Précurseur de plaque d'impression lithographique selon la revendication 6, dans lequel le composé de sel d'onium est un sel d'iodonium, un sel de sulfonium ou un sel d'azinium.

8. Précurseur de plaque d'impression lithographique selon l'une des revendications 1 à 7, dans lequel la couche d'enregistrement d'une image contient en outre un agent absorbant l'infrarouge.

9. Précurseur de plaque d'impression lithographique selon l'une des revendications 1 à 8, qui comprend en outre une couche de protection afin que le support, la couche d'enregistrement d'une image et la couche de protection sont agencés dans cet ordre.

10. Précurseur de plaque d'impression lithographique selon l'une des revendications 1 à 9, dans lequel une sous-couche est agencée entre le support et la couche d'enregistrement d'une image.

11. Précurseur de plaque d'impression lithographique selon l'une des revendications 1 à 10, qui est capable d'imprimer après exposition à une image laser, en montant le précurseur de plaque d'impression lithographique sur une machine d'impression et en alimentant en encre d'impression et en refroidissant de l'eau pour enlever une zone non-exposée de la couche d'enregistrement d'une image.

12. Précurseur de plaque d'impression lithographique selon l'une des revendications 1 à 11, dans lequel le composé polymère est choisi parmi un ou plusieurs types de polymères P-1 à P-14 listés dans le tableau suivant, dans lequel le noyau central SB-2 présente un rapport du nombre de moles en pourcentage de groupe SH au nombre total de moles de monomères de 1%, dans lequel SB-2 représente de l'hexakis(3-mercaptopropionate) dipentaerythritol et dans lequel M_{w} représente une masse moléculaire moyenne en poids mesurée par GPC calculée en termes de polystyrène.
| Polymère n° | Noyau central | Groupe polymérisable (% par mole) | Groupe hydrophile (% par mole) | Autre (% par mole) | Mw (x10⁴) |
|---|---|---|---|---|---|
| P-1 | SB-2 | 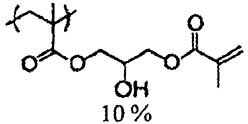 | 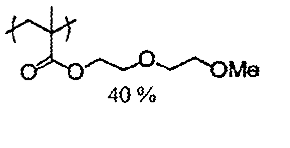 | 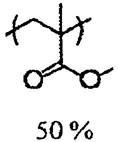 | 6,5 |
| P-2 | SB-2 | 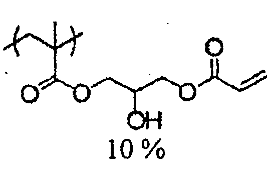 | 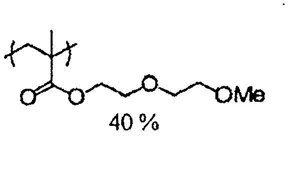 | 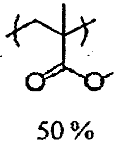 | 6,4 |
| P-3 | SB-2 | 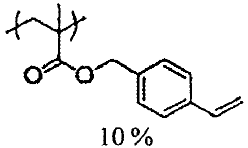 | 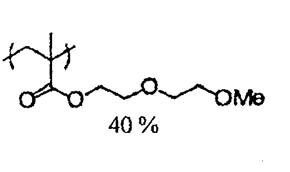 | 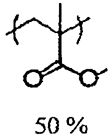 | 6,2 |
| P-4 | SB-2 | 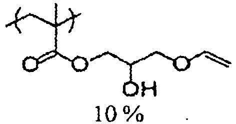 | 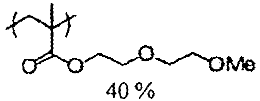 | 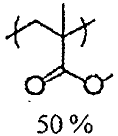 | 6,6 |
| P-5 | SB-2 | 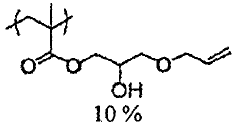 | 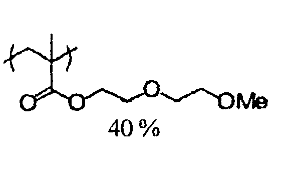 | 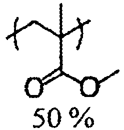 | 6,7 |
| P-6 | SB-2 | 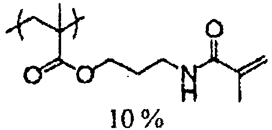 | 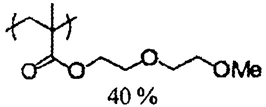 | 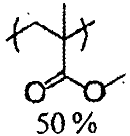 | 6,9 |
| P-7 | SB-2 | 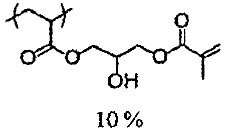 | 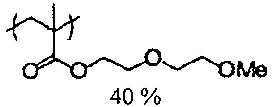 | 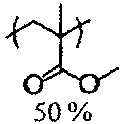 | 6,1 |
| P-8 | SB-2 | 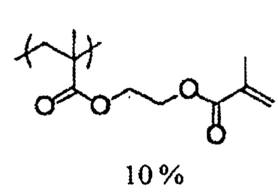 | 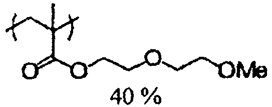 | 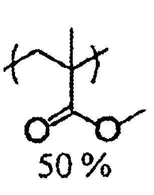 | 7,1 |
| P-9 | SB-2 | 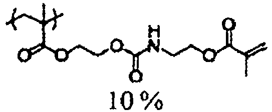 | 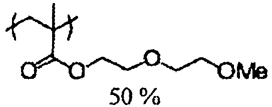 | 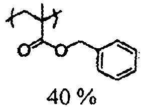 | 6,6 |
| P-10 | SB-2 | 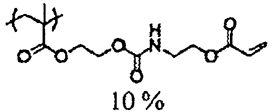 | 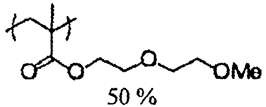 | 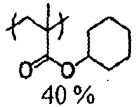 | 6,2 |
| P-11 | SB-2 | 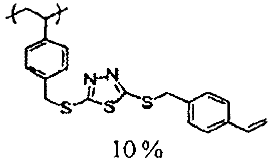 | 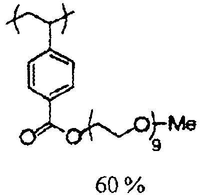 | 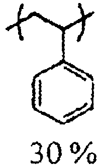 | 5,8 |
| P-12 | SB-2 | 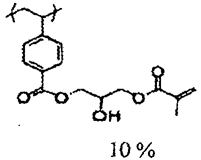 | 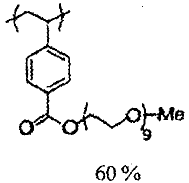 | 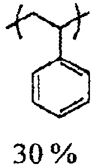 | 5,7 |
| P-13 | SB-2 | 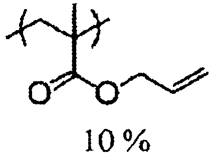 | 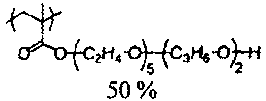 | 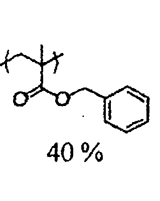 | 7,8 |
| P-14 | SB-2 | 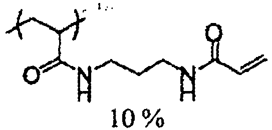 | 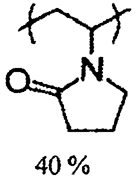 | 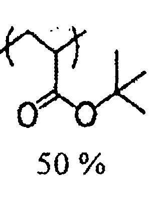 | 7,0 |

13. Procédé d'impression lithographique comprenant, après l'exposition d'une image avec un laser d'un précurseur de plaque d'impression lithographique selon la revendication 11, le montage du précurseur de plaque d'impression lithographique exposé sur une machine d'impression et l'alimentation en encre d'impression et le refroidissement de l'eau pour enlever une zone non-exposée de la couche d'enregistrement d'une image, pour réaliser l'impression.
